# EUROPEAN PATENT SPECIFICATION

(11) **EP 4 560 610 B1**
(45) Date of publication and mention of the grant of the patent: **07.10.2026**
(21) Application number: 24741315.6
(22) Date of filing: 11.01.2024
(51) Int. Cl.: G06F 1/16, G09F 9/30, H04M 1/02

(54) **DISPLAY MODULE AND ELECTRONIC DEVICE**
ANZEIGEMODUL UND ELEKTRONISCHE VORRICHTUNG
MODULE D'AFFICHAGE ET DISPOSITIF ÉLECTRONIQUE

(30) Priority: 13.01.2023 CN 202310094100
(43) Date of publication of application: 28.05.2025
(73) Proprietor: Huawei Technologies Co., Ltd., Shenzhen, Guangdong 518129 (CN)
(72) Inventor: MAO, Weihua, Shenzhen, Guangdong 518129 (CN); YU, Weidong, Shenzhen, Guangdong 518129 (CN); SHENG, Jianqing, Shenzhen, Guangdong 518129 (CN); DAI, Xiaotao, Shenzhen, Guangdong 518129 (CN); WU, Bo, Shenzhen, Guangdong 518129 (CN); ZHA, Peng, Shenzhen, Guangdong 518129 (CN); HUANG, Bo, Shenzhen, Guangdong 518129 (CN)
(74) Representative: MERH-IP Matias Erny Reichl Hoffmann Patentanwälte PartG mbB
(86) International application number: PCT/CN2024/071752
(87) International publication number: WO 2024/149319

(56) References cited:
- EP-A1- 4 064 260
- WO-A1-2020/168971
- WO-A1-2021/197172
- CN-A- 110 738 933
- CN-A- 114 041 180
- CN-A- 115 171 532
- CN-A- 115 547 189
- KR-A- 20160 083 608
- US-A1- 2021 280 095

## Description

### TECHNICAL FIELD

This application relates to the field of display device technologies, and in particular, to a display module and an electronic device.

### BACKGROUND

In a foldable electronic product, a support member is usually disposed at the bottom of a flexible display, to support the flexible display by using the support member. In addition, the support member is provided with through holes and/or grooves, to enhance bendability of the support member. However, because the support member is provided with the through holes and/or the grooves, an anti-extrusion capability and an anti-impact capability of the support member are poor, resulting in poor reliability and a short service life of a display module.

Document EP4064260A1 discloses a display module and an electronic device. A display screen of the display module includes a first buffer member, and a first non-bending region, a bending region, and a second non-bending region that are successively connected. A support member is fastened on a non-display side of the display screen. A first metal plate member of the support member faces the first non-bending region. A first connection plate member of the support member faces the bending region. A second metal plate member of the support member faces the second non-bending region. The first connection plate member is capable of being bent. A metal part of the first connection plate member is provided with a plurality of grooves. Openings of the plurality of grooves are located on a first surface of the metal part. Organic material parts of the first connection plate member are located in the plurality of grooves, and are fixedly connected to the metal part. The first buffer member is located between the first metal plate member and the second metal plate member. The first buffer member is stacked on the first surface of the metal part, and is fixedly connected to the organic material parts.

### SUMMARY

This application provides a display module and an electronic device that can balance bendability and reliability.

Embodiments of the present invention are defined by the independent claims. Additional features of embodiments of the invention are presented in the dependent claims. In the following, parts of the description and drawings referring to former embodiments which do not necessarily comprise all features to implement embodiments of the claimed invention are not represented as embodiments of the invention but as examples useful for understanding the embodiments of the invention.

### BRIEF DESCRIPTION OF DRAWINGS

To describe technical solutions in embodiments of this application, the following describes accompanying drawings used in embodiments of this application.
FIG. 1 is a diagram of a structure of an electronic device in an open state according to an embodiment of this application;
FIG. 2 is a diagram of a structure of an implementation of the electronic device shown in FIG. 1 in a closed state;
FIG. 3 is a partial sectional view of an implementation of the electronic device shown in FIG. 2 at an A-A line;
FIG. 4 is a partial exploded diagram of an implementation of the electronic device shown in FIG. 1;
FIG. 5 is a partial exploded diagram of an implementation of a display module shown in FIG. 4;
FIG. 6 is a partial enlarged view of an implementation of a support member shown in FIG. 5 at a position B;
FIG. 7 is a partial sectional view of an implementation of a display module shown in FIG. 4 at a C-C line;
FIG. 8 is a partial sectional view of an implementation of the display module shown in FIG. 7 in a folded state;
FIG. 9 is a partial sectional view of an implementation of the display module shown in FIG. 7, a first door board, and a second door board;
FIG. 10 is a diagram of a structure of another implementation of an electronic device in a closed state according to an embodiment of this application;
FIG. 11a is a partial sectional view of an implementation of the electronic device shown in FIG. 10 at a D-D line;
FIG. 11b is a partial enlarged view of an implementation of the electronic device shown in FIG. 11a at a position E;
FIG. 12a is a diagram of a structure of another implementation of the display module shown in FIG. 5;
FIG. 12b is a partial sectional view of an implementation of the display module shown in FIG. 12a in a closed state;
FIG. 13 is a diagram of a structure of still another implementation of the display module shown in FIG. 5;
FIG. 14a is a diagram of a structure of yet another implementation of the display module shown in FIG. 5;
FIG. 14b is a partial sectional view of an implementation of the display module shown in FIG. 14a in a closed state;
FIG. 15a is a diagram of a structure of still yet another implementation of the display module shown in FIG. 5;
FIG. 15b is a partial sectional view of an implementation of the display module shown in FIG. 15a in an open state at an F-F line;
FIG. 16 is a diagram of a structure of another implementation of an electronic device in an open state according to this application;
FIG. 17 is a diagram of a structure of an implementation of the electronic device shown in FIG. 16 in a closed state;
FIG. 18 is a partial sectional view of an implementation of the electronic device shown in FIG. 17 at a G-G line;
FIG. 19a is a partial exploded diagram of an implementation of the electronic device shown in FIG. 16;
FIG. 19b is a partial exploded diagram of another implementation of the electronic device shown in FIG. 16;
FIG. 20 is a partial exploded diagram of an implementation of a display module shown in FIG. 19a;
FIG. 21 is a partial sectional view of an implementation of a display module shown in FIG. 19a at a J-J line;
FIG. 22 is a sectional view of an implementation of a display module shown in FIG. 19a in a folded state;
FIG. 23 is a diagram of a structure of another implementation of the display module shown in FIG. 20;
FIG. 24 is a partial sectional view of an implementation of the display module shown in FIG. 23 in an open state at a K-K line;
FIG. 25 is a diagram of a structure of still another implementation of the display module shown in FIG. 20;
FIG. 26 is a diagram of still another implementation of an electronic device in a closed state according to this application;
FIG. 27 is a partial sectional view of an implementation of a display module shown in FIG. 26 at an M-M line;
FIG. 28 is a diagram of yet another implementation of an electronic device in a closed state according to an embodiment of this application; and
FIG. 29 is a partial sectional view of an implementation of a display module shown in FIG. 28 at an N-N line.

### DESCRIPTION OF EMBODIMENTS

In descriptions of embodiments of this application, it should be noted that, unless otherwise clearly specified and limited, a term "connection" should be understood in a broad sense. For example, the "connection" may be a detachable connection, a nondetachable connection, a direct connection, or an indirect connection through an intermediate medium. "Fastened" may be a connection to each other and a relative position relationship unchanged after the connection. "Rotatable connection" may be a connection to each other and a relative rotation after the connection. "Slidable connection" may be a connection to each other and a relative slide after the connection. Orientation terms mentioned in embodiments of this application, for example, "up", "down", "inside", and "outside", are merely directions with reference to the accompanying drawings. Therefore, the orientation terms are used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application. The terms such as "first" and "second" below are merely intended for a purpose of description, and shall not be understood as an indication or implication of relative importance or an implicit indication of a quantity of indicated technical features. Therefore, a feature limited by "first" or "second" may explicitly or implicitly include one or more features. In addition, "a plurality of" means at least two. In embodiments of this application, the term "and/or" describes only an association relationship between associated objects and indicates that three relationships may exist. For example, A and/or B may indicate the following three cases: Only A exists, both A and B exist, and only B exists. In addition, the character "/" in this specification generally indicates an "or" relationship between the associated objects.

The following describes embodiments of this application with reference to the accompanying drawings in embodiments of this application.

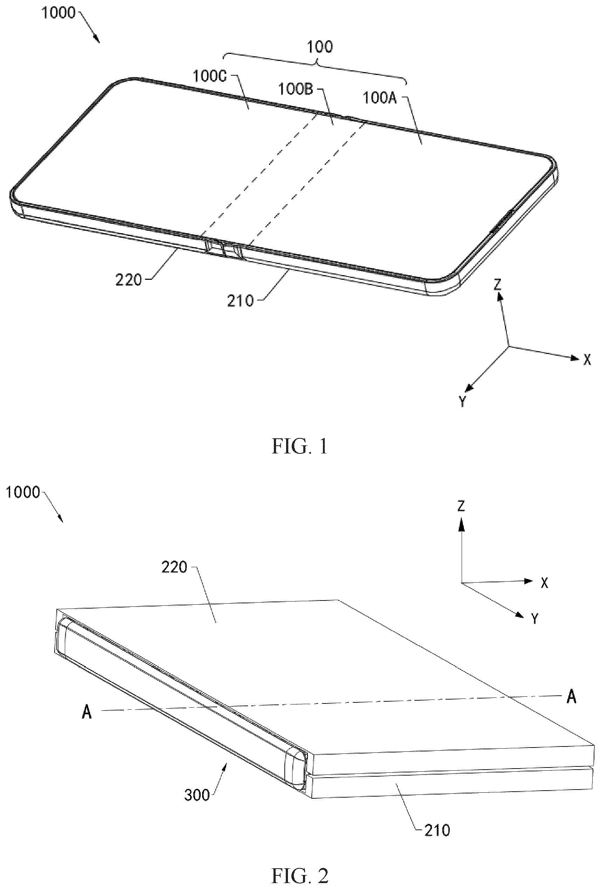

FIG. 1 is a diagram of a structure of an electronic device 1000 in an open state according to an embodiment of this application. FIG. 2 is a diagram of a structure of an implementation of the electronic device 1000 shown in FIG. 1 in a closed state.

As shown in FIG. 1 and FIG. 2, the electronic device 1000 may be a foldable device like a mobile phone, a tablet computer, a personal computer, a notebook computer, a vehicle-mounted device, or a wearable device. In the embodiment shown in FIG. 1, the electronic device 1000 is described by using a mobile phone as an example.

For ease of description, for example, a thickness direction of the electronic device 1000 is defined as a Z-axis direction, and an extension direction of a rotation axis of the electronic device 1000 is defined as a Y-axis direction, that is, a width direction of the electronic device 1000 is defined as the Y-axis direction. A direction perpendicular to the Y-axis direction and the Z-axis direction is an X-axis direction, that is, a length direction of the electronic device 1000 is an X-axis. It may be understood that a coordinate system of the electronic device 1000 may alternatively be flexibly set based on a specific requirement. In this implementation, when the direction of the rotation axis of the electronic device 1000 is the Y-axis direction, the electronic device 1000 may be unfolded or folded in the Y-axis direction. In this way, when the electronic device 1000 is in the closed state, a size of the electronic device 1000 in the X-axis direction is reduced.

As shown in FIG. 1 and FIG. 2, the electronic device 1000 includes a display module 100, a first housing 210, a second housing 220, and a first folding mechanism 300. The first folding mechanism 300 is connected between the first housing 210 and the second housing 220. The first folding mechanism 300 is configured to unfold or fold the first housing 210 and the second housing 220 relative to each other.

It may be understood that, as shown in FIG. 1, when the first housing 210 and the second housing 220 are unfolded relative to each other to a flattened state, the electronic device 1000 is in a flattened state, and the first housing 210 and the second housing 220 may be 180° apart. In another embodiment, the first housing 210 and the second housing 220 may alternatively be apart at another angle, for example, 165°, 177°, or 185°.

As shown in FIG. 2, when the first housing 210 and the second housing 220 are folded relative to each other to a closed state, the electronic device 1000 is in the closed state, and the first housing 210 and the second housing 220 may be close to each other.

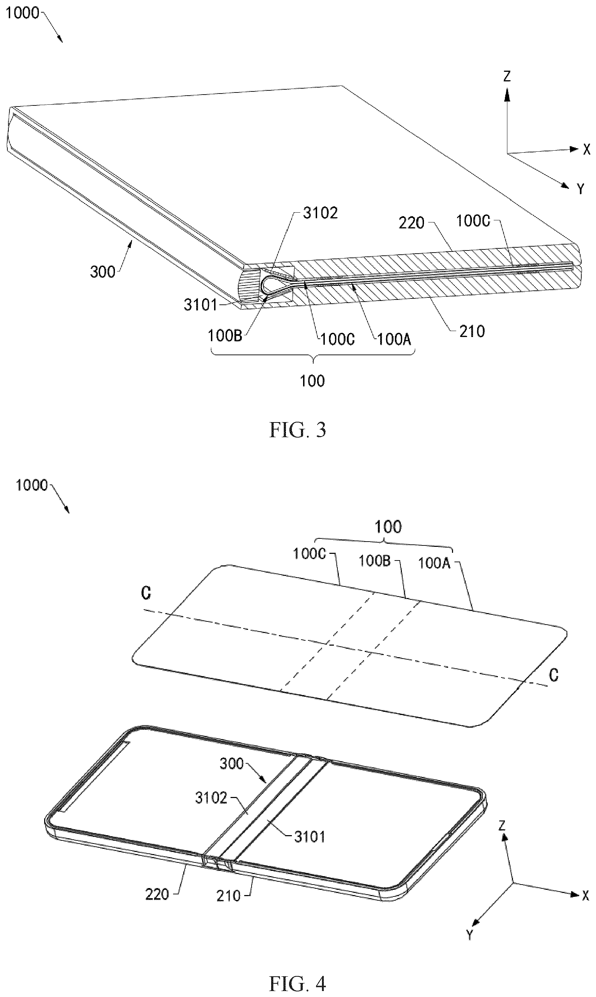

FIG. 3 is a partial sectional view of an implementation of the electronic device 1000 shown in FIG. 2 at an A-A line.

As shown in FIG. 1 and FIG. 3, the display module 100 includes a first portion 100A, a second portion 100B, and a third portion 100C that are sequentially connected. The second portion 100B is connected between the first portion 100A and the third portion 100C. For example, in FIG. 1, an example in which the first portion 100A, the second portion 100B, and the third portion 100C are arranged in the X-axis direction is used for illustration.

As shown in FIG. 1 and FIG. 3, the first portion 100A of the display module 100 may be fastened to the first housing 210. The third portion 100C may be fastened to the second housing 220. The second portion 100B may be disposed opposite to the first folding mechanism 300. When the first folding mechanism 300 unfolds or folds the first housing 210 and the second housing 220 relative to each other, the first housing 210 may drive the first portion 100A of the display module 100 to be unfolded or folded, and the second housing 220 may drive the third portion 100C of the display module 100 to be unfolded or folded. In this case, the second portion 100B of the display module 100 is bent.

As shown in FIG. 1, when the electronic device 1000 is in the open state, the display module 100 may be in a flattened state. For example, the first portion 100A, the second portion 100B, and the third portion 100C of the display module 100 may be approximately 180° apart (a slight deviation, for example, 165°, 177°, or 185°, is allowed). In this case, the display module 100 has a large continuous display region. In other words, the display module 100 can implement large-screen display, so that user experience is good.

As shown in FIG. 2 and FIG. 3, when the electronic device 1000 is in the closed state, the display module 100 may be in a folded state. That is, the second portion 100B of the display module 100 is bent, and the first portion 100A and the third portion 100C of the display module 100 are located between the first housing 210 and the second housing 220. In this case, an area of the display module 100 is small. This helps reduce a probability that the display module 100 is damaged.

In this implementation, when the electronic device 1000 is in the closed state, the first portion 100A and the third portion 100C of the display module 100 may be accommodated between the first housing 210 and the second housing 220. In this case, the second portion 100B of the display module 100 is in an inward-bending structure, and the electronic device 1000 is an inward-bending device. In another implementation, when the electronic device 1000 is in the closed state, the first housing 210 and the second housing 220 may alternatively be accommodated between the first portion 100Aand the third portion 100C of the display module 100. In this case, the display module 100 is in an outward-bending structure, and the electronic device 1000 is an outward-bending device. Specific descriptions are provided below with reference to related accompanying drawings.

FIG. 4 is a partial exploded diagram of an implementation of the electronic device 1000 shown in FIG. 1.

As shown in FIG. 4, the first folding mechanism 300 includes a first door board 3101 and a second door board 3102.

For example, when the electronic device 1000 is unfolded to the open state, the first door board 3101 and the second door board 3102 may jointly support the second portion 100B of the display module 100, to improve an anti-extrusion capability and an anti-impact capability of the second portion 100B.

As shown in FIG. 3, when the electronic device 1000 is folded to the closed state, the first door board 3101 and the second door board 3102 may apply an action force to the second portion 100B of the display module 100, to form the second portion 100B into a specific shape, thereby reducing a volume of space occupied by the second portion 100B to a large extent. For example, the second portion 100B may be in a shape of a water droplet, a baseball, or the like.

For example, both the first door board 3101 and the second door board 3102 are fastened to the second portion 100B of the display module 100. In this way, in a process of folding the electronic device 1000, the first door board 3101 and the second door board 3102 may pull the second portion 100B of the display module 100 to bend in a direction close to the first door board 3101 and the second door board 3102, to avoid the second portion 100B of the display module 100 from arching in a direction away from the first door board 3101 and the second door board 3102, that is, to avoid a problem of arching of the second portion 100B of the display module 100.

It may be understood that, in some solutions, because there is a gap between the first door board 3101 and the second door board 3102, when the electronic device 1000 is in the flattened state, a position that is in the display module and that is disposed directly opposite to the gap is in an unsupported state. In this case, when a user touches the position, the display module is likely to be dented at the position. That is, the anti-extrusion capability and the anti-impact capability of the display module are poor. In addition, in some solutions, some avoidance holes or avoidance grooves are provided on the first door board 3101 and the second door board 3102. Therefore, when the electronic device 1000 is in the flattened state, a position that is in the display module and that is disposed directly opposite to the avoidance hole or the avoidance groove is in an unsupported state. In this case, when the user touches the position, the display module is also likely to be dented at the position. That is, the anti-extrusion capability and the anti-impact capability of the display module are poor. However, in this application, the display module 100 having a good anti-extrusion capability and a good anti-impact capability is disposed, so that when the electronic device 1000 is in the flattened state, the position that is in the display module 100 and that is disposed directly opposite to the gap still has a good anti-extrusion capability and a good anti-impact capability, and the position that is in the display module 100 and that is disposed directly opposite to the avoidance hole or the avoidance groove also still has a good anti-extrusion capability and a good anti-impact capability. The following specifically describes a structure of the display module 100 with reference to related accompanying drawings.

It may be understood that, although FIG. 4 shows that the first folding mechanism 300 includes two door boards, namely, the first door board 3101 and the second door board 3102, in another implementation, the first folding mechanism 300 may further include a third door board, a fourth door board, and the like. The third door board and the fourth door board may be located between the first door board 3101 and the second door board 3102. This is not specifically limited in this application.

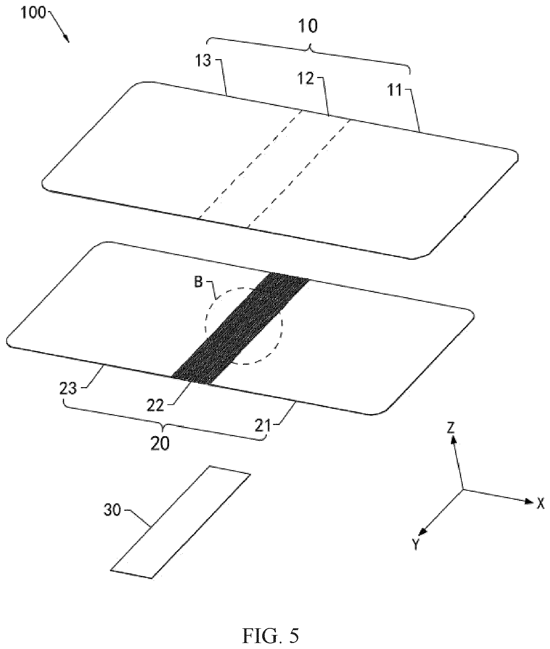

FIG. 5 is a partial exploded diagram of an implementation of the display module 100 shown in FIG. 4.

As shown in FIG. 5, the display module 100 includes a display 10, a support member 20, and a first stiffening plate 30. The display 10 is configured to display an image, a text, a video, and the like. The display 10 may be a flexible display. For example, the display 10 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, or a quantum dot light-emitting diode (quantum dot light-emitting diode, QLED) display.

For example, the display 10 may include structures such as a back film (not shown in the figure), a display panel (not shown in the figure), a polarizer (Polarizer, POL) (not shown in the figure), and a protective cover (not shown in the figure). The display panel is configured to display an image, a video, and the like. In an implementation, the display 10 may further include a touchpad (not shown in the figure) and the like.

As shown in FIG. 5, the display 10 includes a first non-bending portion 11, a first bending portion 12, and a second non-bending portion 13 that are sequentially connected. That is, the first bending portion 12 is connected between the first non-bending portion 11 and the second non-bending portion 13. The first non-bending portion 11 is a part of the first portion 100A (refer to FIG. 4) of the display module 100. The first bending portion 12 is a part of the second portion 100B (refer to FIG. 4). The second non-bending portion 13 is a part of the third portion 100C (refer to FIG. 4). It may be understood that, in FIG. 5, the first non-bending portion 11, the first bending portion 12, and the second non-bending portion 13 are schematically distinguished by dashed lines.

As shown in FIG. 5, when the electronic device 1000 is in the open state, the first non-bending portion 11, the first bending portion 12, and the second non-bending portion 13 of the display 10 may be approximately 180° apart (a slight deviation, for example, 165°, 177°, or 185°, is allowed).

As shown in FIG. 3, when the electronic device 1000 is in the closed state, the first bending portion 12 is bent, and the first non-bending portion 11 and the second non-bending portion 13 are close to each other and may be disposed facing each other.

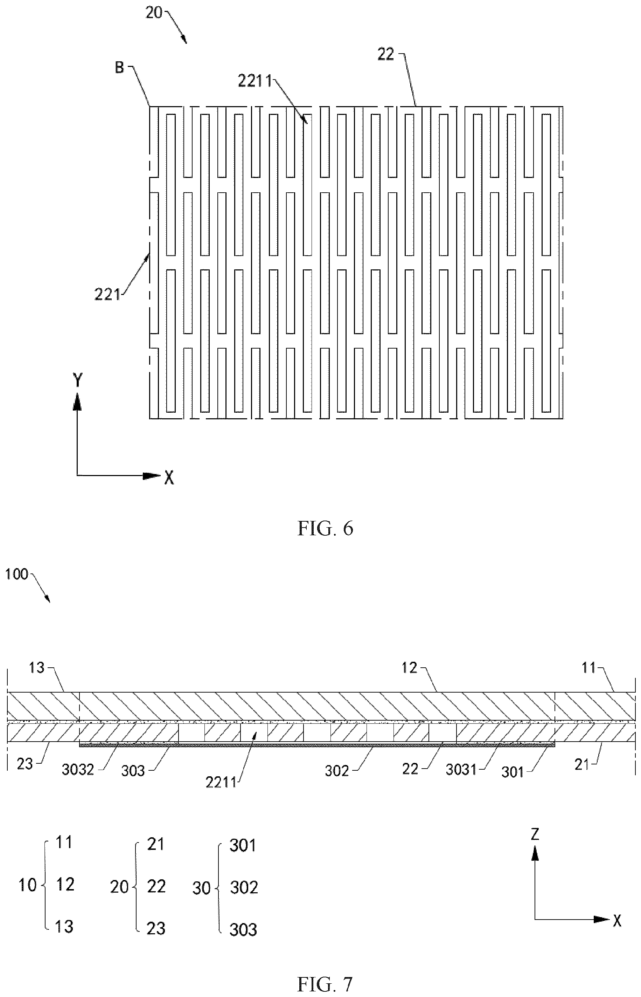

FIG. 6 is a partial enlarged view of an implementation of the support member 20 shown in FIG. 5 at a position B.

As shown in FIG. 5 and FIG. 6, the support member 20 includes a first support portion 21, a second support portion 22, and a third support portion 23 that are sequentially connected. In other words, the second support portion 22 is connected between the first support portion 21 and the third support portion 23.

It may be understood that the first support portion 21, the second support portion 22, and the third support portion 23 are an integral structure. That is, the support member 20 is an integrally formed structural member. In this case, the first support portion 21, the second support portion 22, and the third support portion 23 are more firmly connected. In addition, the first support portion 21, the second support portion 22, and the third support portion 23 are formed in fewer steps, so that costs of preparing the support member 20 can be reduced. In another implementation, the first support portion 21, the second support portion 22, and the third support portion 23 may alternatively be formed by welding or connected by snap-fitting.

As shown in FIG. 6, the second support portion 22 of the support member 20 is provided with first through holes 2211. In this way, compared with a solution in which the second support portion 22 is not provided with the first through holes 2211, the second support portion 22 in this implementation is more bendable. That is, flexibility is better.

For example, the second support portion 22 of the support member 20 is provided with a plurality of through hole groups 221. The plurality of through hole groups 221 are spaced from each other in the X-axis direction. In addition, each through hole group 221 includes a plurality of first through holes 2211. The plurality of first through holes 2211 are spaced from each other in the Y-axis direction. In this way, the second support portion 22 has better bendability.

In another implementation, the second support portion 22 of the support member 20 may alternatively be provided with first grooves (not shown in the figure). That is, the first through holes 2211 shown in FIG. 6 are replaced with the first grooves. In another implementation, the second support portion 22 of the support member 20 may alternatively be provided with both the first through holes 2211 and the first grooves. It may be understood that the following uses the first through holes 2211 as an example for description.

In some implementations, a material of the support member 20 may be a metal material, for example, stainless steel, a titanium alloy, or an aluminum alloy, or may be another composite material, for example, glass fiber or carbon fiber.

In some implementations, the material of the support member 20 is carbon fiber. It may be understood that the carbon fiber has high strength and a high modulus in a fiber axis direction of the carbon fiber, and density of the carbon fiber is small. Therefore, specific strength and a specific modulus of the carbon fiber are high. Therefore, the support member 20 that is prepared by using the carbon fiber may maintain a small weight while the strength of the support member 20 is high. This helps lighten the electronic device 1000 and improve user experience.

FIG. 7 is a partial sectional view of an implementation of the display module 100 shown in FIG. 4 at a C-C line.

As shown in FIG. 7, the support member 20 is fastened to a non-display side of the display 10. The first support portion 21 is connected to the first non-bending portion 11 of the display 10. The first through holes 2211 are provided opposite to the first bending portion 12. The second support portion 22 is connected to the first bending portion 12 of the display 10. The third support portion 23 is connected to the second non-bending portion 13.

For example, the first support portion 21 may be connected to the first non-bending portion 11 of the display 10 by using an adhesive. The second support portion 22 may also be connected to the first bending portion 12 of the display 10 by using an adhesive. The third support portion 23 may be connected to the second non-bending portion 13 by using an adhesive. For example, the adhesive may be an OCA (optically clear adhesive) optical adhesive, a PVB (polyvinyl butyral) adhesive, a foam adhesive, or a combination material thereof.

As shown in FIG. 7, when the electronic device 1000 is in the open state, the first support portion 21 may be configured to support the first non-bending portion 11 of the display 10, the second support portion 22 may be configured to support the first bending portion 12 of the display 10, and the third support portion 23 may be configured to support the second non-bending portion 13 of the display 10.

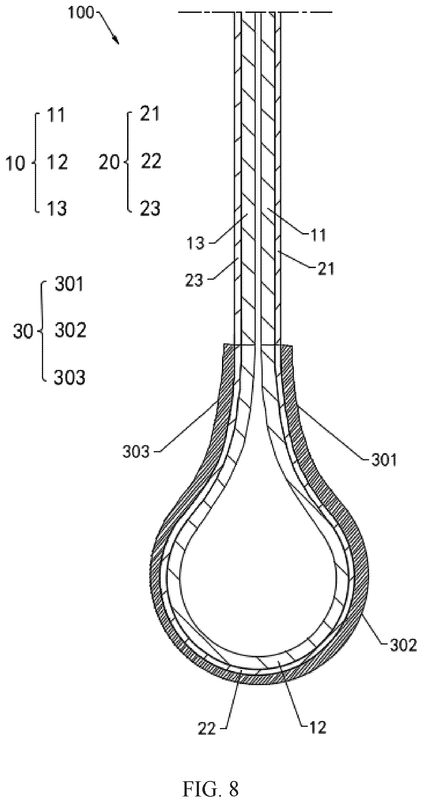

FIG. 8 is a partial sectional view of an implementation of the display module 100 shown in FIG. 7 in the folded state.

As shown in FIG. 8, when the electronic device 1000 is in the closed state, the second support portion 22 of the support member 20 is bent, and the first non-bending portion 11 and the second non-bending portion 13 are located between the first support portion 21 and the third support portion 23.

As shown in FIG. 7 and FIG. 8, the first stiffening plate 30 is fastened to a side that is of the support member 20 and that is away from the first bending portion 12 and covers the first through holes 2211. In this way, the first stiffening plate 30 can improve structural strength of the second support portion 22 of the support member 20, that is, improve an anti-bending capability of the second support portion 22. When the first housing 210 (refer to FIG. 4) and the second housing 220 (refer to FIG. 4) are unfolded or folded relative to each other, both the support member 20 and the first stiffening plate 30 are bendable.

It may be understood that, because the first stiffening plate 30 is fastened to the side that is of the support member 20 and that is away from the first bending portion 12 and covers the first through holes 2211, the first stiffening plate 30 may cover the first through holes 2211 on the second support portion 22. In this way, when the display module 100 is in the flattened state, a position that is in the display module 100 and that is disposed directly opposite to the first through hole 2211 may still be supported by the first stiffening plate 30. In this case, when the user touches the position, the display module 100 is not likely to be dented at the position. That is, the anti-extrusion capability and the anti-impact capability of the display module 100 are good.

In addition, the first stiffening plate 30 may further cover the gap between the first door board 3101 (refer to FIG. 4) and the second door board 3102 (refer to FIG. 4), the avoidance hole or the avoidance groove on the first door board 3101 (refer to FIG. 4), or the avoidance hole or the avoidance groove on the second door board 3102 (refer to FIG. 4). In this way, when the display module 100 is in the flattened state, a position that is in the display module 100 and that is disposed directly opposite to the gap, the avoidance hole, or the avoidance groove may still be supported by the first stiffening plate 30. In this case, when the user touches the position, the display module 100 is not likely to be dented at the position. That is, the anti-extrusion capability and the anti-impact capability of the display module 100 are good.

As shown in FIG. 8, when the display module 100 is in the folded state, the display module 100 is likely to be impacted by external stress (for example, extrusion stress or impact stress), and the first stiffening plate 30 may transmit the stress on the display module 100 through a connection, to avoid local stress concentration, thereby improving the anti-extrusion capability and the anti-impact capability of the display module 100.

As shown in FIG. 7 and FIG. 8, the first stiffening plate 30 may be fastened, by using a first adhesive 3031 and a second adhesive 3032, to a side that is of the second support portion 22 and that is away from the display 10. For example, the first adhesive 3031 and the second adhesive 3032 may be an OCA optical adhesive, a PVB adhesive, a foam adhesive, or a combination material thereof.

As shown in FIG. 7, the first stiffening plate 30 includes a first side portion 301, a middle portion 302, and a second side portion 303. The first side portion 301 is close to the first non-bending portion 11. The second side portion 303 is close to the second non-bending portion 13. The first adhesive 3031 and the second adhesive 3032 are spaced apart. The first side portion 301 is fastened to a first position of the support member 20 by using the first adhesive 3031. The second side portion 303 is fastened to a second position of the support member 20 by using the second adhesive 3032.

It may be understood that, compared with a solution in which an entire surface of the first stiffening plate 30 is fastened to the support member 20, in this implementation, the first side portion 301 and the second side portion 303 of the first stiffening plate 30 are fastened to the support member 20. That is, the middle portion 302 of the first stiffening plate 30 is not fastened to the support member 20, so that a degree of freedom of the middle portion 302 of the first stiffening plate 30 is released. To be specific, bending of the middle portion of the first stiffening plate 30 is not restrained by the support member 20. In this way, in a process of folding or flattening the display module 100, a risk of layering is not likely to occur on the display module 100, and a rebound force of the display module 100 can also be reduced.

In another implementation, the first adhesive 3031 may alternatively be connected to the second adhesive 3032.

For example, a thickness of the first stiffening plate 30 ranges from 0.01 cm to 0.05 cm. In this way, the first stiffening plate 30 has bendability, so that it may be ensured that the second portion 100B of the display module 100 has good bendability in a process of folding and unfolding the electronic device 1000. It may be understood that, in a process of unfolding or folding the electronic device 1000, the first stiffening plate 30 has specific flexibility, and has little impact on bending of the display 10.

For example, a hardness of the first stiffening plate 30 is greater than 50 Brinell hardness (Brinell hardness, HB). In this way, the first stiffening plate 30 has sufficient strength to support the display 10.

For example, a material of the first stiffening plate 30 may be steel. It may be understood that steel has high strength and good toughness, so that an anti-extrusion capability and an anti-impact capability are strong. In addition, steel is cheap. This helps reduce product costs. In another implementation, the material of the first stiffening plate 30 may alternatively be another material like copper, aluminum, or a titanium alloy, or another material whose hardness is greater than 50 HB.

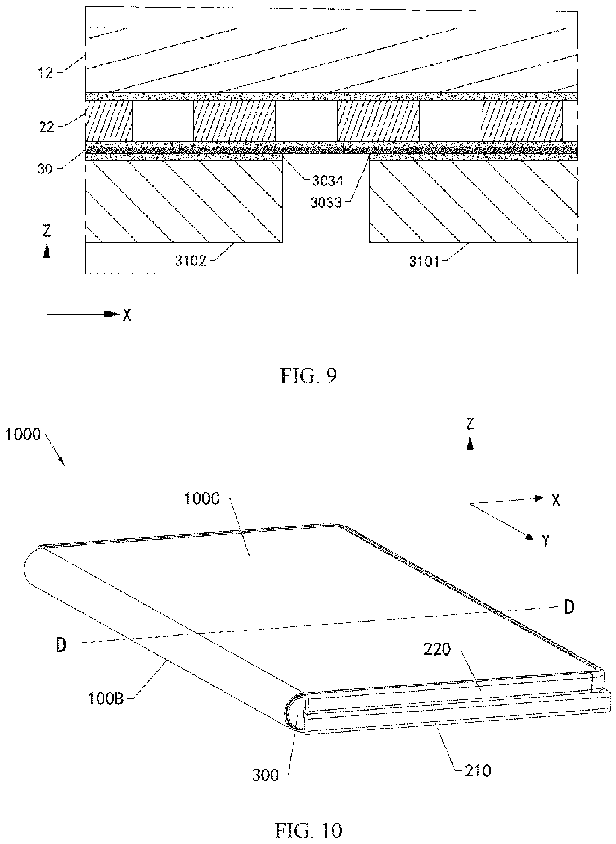

FIG. 9 is a partial sectional view of an implementation of the display module 100 shown in FIG. 7, the first door board 3101, and the second door board 3102.

As shown in FIG. 9, the first stiffening plate 30 is fastened to both the first door board 3101 and the second door board 3102.

For example, the first stiffening plate 30 may be fastened to the first door board 3101 by using a third adhesive 3033. The first stiffening plate 30 may be further fastened to the second door board 3102 by using a fourth adhesive 3034. For example, the second adhesive 304 may be an OCA optical adhesive, a PVB adhesive, a foam adhesive, or a combination material thereof. The third adhesive 3033 and the fourth adhesive 3034 may be spaced apart.

In another implementation, the third adhesive 3033 may alternatively be connected to the fourth adhesive 3034.

In another implementation, a manner of connecting the first stiffening plate 30 to the first door board 3101 and the second door board 3102 is not limited.

It may be understood that, compared with a solution in which the first stiffening plate 30 is not connected to the first door board 3101 and the second door board 3102, or a solution in which a part of the first stiffening plate 30 is fastened to the first door board 3101 and another part of the first stiffening plate 30 is separately disposed from (that is, not connected to) the second door board 3102, in this implementation, the first stiffening plate 30 is connected to both the first door board 3101 and the second door board 3102, so that in a process of unfolding or folding the electronic device 1000, the first door board 3101 and the second door board 3102 may drive the first stiffening plate 30, the second support portion 22 of the support member 20, and the first bending portion 12 of the display 10 to bend in a direction close to the first door board 3101 and the second door board 3102. In other words, the first stiffening plate 30, the second support portion 22 of the support member 20, and the first bending portion 12 of the display 10 are prevented from arching in a direction away from the first door board 3101 and the second door board 3102. Therefore, the display module 100 in this implementation has good anti-arching performance.

In addition, in this implementation, the first stiffening plate 30 is connected to both the first door board 3101 and the second door board 3102, so that in the process of unfolding or folding the electronic device 1000, the first door board 3101 and the second door board 3102 may restrain a motion status of the display module 100, thereby avoiding a problem like a sharp corner or a dead fold caused by shaking of the display module 100, and avoiding a failure of the display module 100. That is, the display module 100 in this implementation has good reliability.

In addition, in this implementation, the first stiffening plate 30 is connected to both the first door board 3101 and the second door board 3102, so that when the electronic device 1000 falls, the display module 100 may transfer a collision force to the first door board 3101 and the second door board 3102, thereby avoiding damage to the display module 100 to a large extent. In this way, an anti-drop capability of the display module 100 in this implementation is good.

The foregoing specifically describes several implementations of the display module 100 and the electronic device 1000 with reference to related accompanying drawings. The following further specifically describes several implementations of the display module 100 and the electronic device 1000 with reference to related accompanying drawings.

In a second implementation, technical content that is the same as that in the foregoing implementation is not described again.

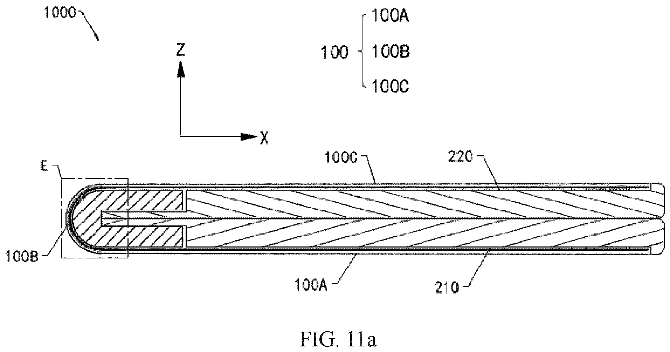

FIG. 10 is a diagram of a structure of another implementation of an electronic device 1000 in a closed state according to an embodiment of this application. FIG. 11a is a partial sectional view of an implementation of the electronic device 1000 shown in FIG. 10 at a D-D line.

As shown in FIG. 10 and FIG. 11a, when the electronic device 1000 is in the closed state, a display module 100 may be exposed relative to a first housing 210 and a second housing 220, and the first housing 210 and the second housing 220 may be accommodated between a first portion 100A1 and a third portion 100C of the display module 100. In this way, when the electronic device 1000 is in the closed state, a part or all of the display module 100 may be used for display. It may be understood that, when the electronic device 1000 is in the closed state, the first housing 210 and the second housing 220 are accommodated between the first portion 100A and the third portion 100C of the display module 100. In this case, the display module 100 is in an outward-bending structure. That is, the electronic device 1000 is an outward-bending device.

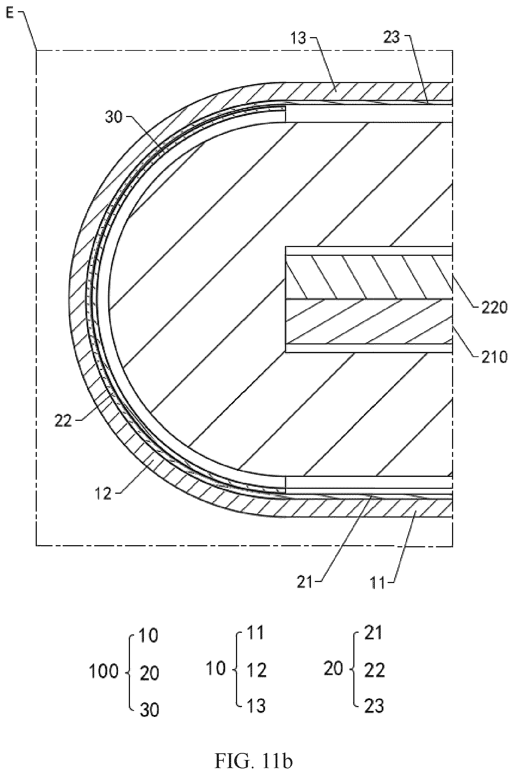

FIG. 11b is a partial enlarged view of an implementation of the electronic device 1000 shown in FIG. 11a at a position E.

As shown in FIG. 11b, the display module 100 includes a display 10, a support member 20, and a first stiffening plate 30. For a disposing manner and a connection relationship of the display 10 and the support member 20, refer to the disposing manner and the connection relationship of the display 10 and the support member 20 in the implementations shown in FIG. 5 to FIG. 9. Details are not described herein again. In addition, for a disposing manner and a connection relationship of the first stiffening plate 30 and the support member 20, refer to the disposing manner and the connection relationship of the first stiffening plate 30 and the support member 20 in the implementations shown in FIG. 7 and FIG. 8. Details are also not described herein again.

As shown in FIG. 11b, when the electronic device 1000 is in the closed state, a second support portion 22 of the support member 20 is bent, and a first support portion 21 and a third support portion 23 are located between a first non-bending portion 11 and a second non-bending portion 13. FIG. 11a shows that a first bending portion 12 is roughly "U"-shaped. In this case, the first housing 210 and the second housing 220 are located between the first non-bending portion 11 and the second non-bending portion 13. It may be understood that the second support portion 22 is disposed at an outer bend of the display module 100. In this way, when the electronic device 1000 is in the closed state, the second support portion 22 of the support member 20 can improve anti-extrusion performance of the display module 100, and bendability is good.

It may be understood that, because the display 10 is exposed to the outside, when the electronic device 1000 falls, the first bending portion 12 of the display 10 is more likely to be damaged due to impact. In addition, due to intersection of extrusion stress and impact stress on the first bending portion 12 of the display 10, reliability of the display 10 is poor. However, in this implementation, the first stiffening plate 30 is disposed, to provide support for the display 10. When a user touches the display 10, a problem of denting is not likely to occur. In addition, an anti-extrusion capability and an anti-impact capability of the display 10 may be enhanced. In the process of folding and unfolding the electronic device 1000, the first bending portion 12 of the display 10 is not likely to be damaged due to extrusion stress. However, when the electronic device 1000 falls, the first bending portion 12 of the display 10 is not likely to fail due to the impact stress generated during the fall.

In a third implementation, technical content that is the same as that in the first implementation and the second implementation is not described again.

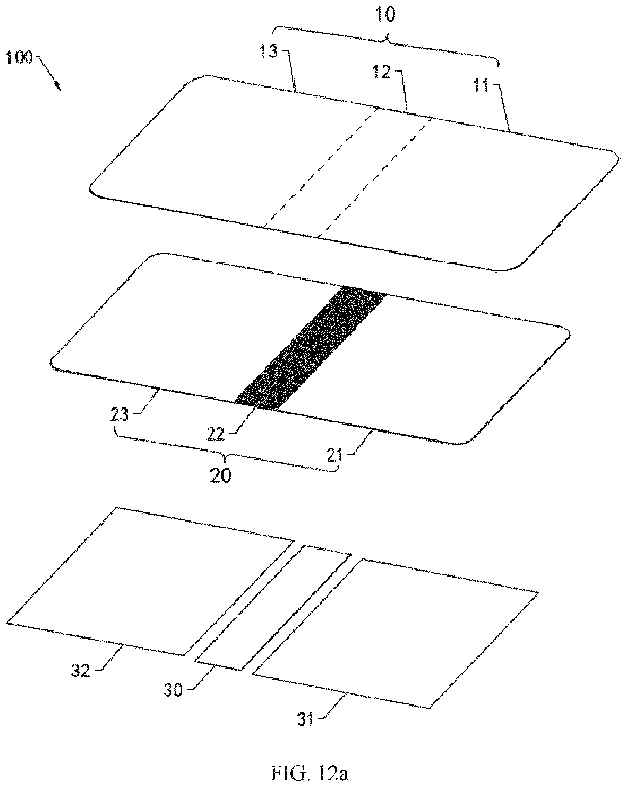

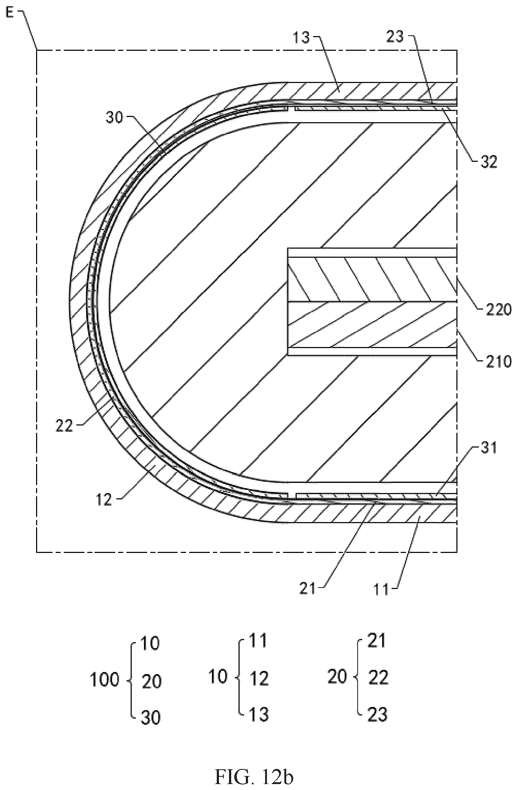

FIG. 12a is a diagram of a structure of another implementation of the display module 100 shown in FIG. 5. FIG. 12b is a partial sectional view of an implementation of the display module 100 shown in FIG. 12a in a closed state.

As shown in FIG. 12a and FIG. 12b, the display module 100 further includes a second stiffening plate 31 and a third stiffening plate 32. Both the second stiffening plate 31 and the third stiffening plate 32 are located on a side that is of the support member 20 and that is away from the display 10. The second stiffening plate 31 may be fastened to the first support portion 21 of the support member 20. The third stiffening plate 32 may be fastened to the third support portion 23 of the support member 20.

For example, the second stiffening plate 31 may be fastened to the first support portion 21 of the support member 20 by using an OCA optical adhesive, a PVB adhesive, a foam adhesive, a combination material thereof, or the like. The third stiffening plate 32 may also be fastened to the third support portion 23 of the support member 20 by using an OCA optical adhesive, a PVB adhesive, a foam adhesive, a combination material thereof, or the like.

It may be understood that the first stiffening plate 30, the second stiffening plate 31, and the third stiffening plate 32 are disposed, so that the anti-extrusion capability and the anti-impact capability of the display module 100 can be improved. When the electronic device 1000 is in a flattened state, the first stiffening plate 30, the second stiffening plate 31, and the third stiffening plate 32 may cooperate with the support member 20 to jointly support the display 10. **In** this way, the display 10 is not likely to collapse due to insufficient support strength. When the electronic device 1000 is in a folded state, the display 10 is exposed to the outside, and is likely to be impacted by external stress (for example, extrusion stress or impact stress). The first stiffening plate 30, the second stiffening plate 31, and the third stiffening plate 32 may cooperate with the support member 20 to transmit stress on the electronic device 1000 through connections, to avoid local stress concentration, thereby improving the reliability of the display module 100, and reducing a risk that the display 10 fails after being subjected to an external impact force. **In** addition, because the display 10 is exposed to the outside, when the electronic device 1000 falls, the display 10 is more likely to be damaged due to impact. **In** addition, due to intersection of extrusion stress and impact stress on the display 10, the reliability of the display 10 is poor. However, in this implementation, the first stiffening plate 30, the second stiffening plate 31, and the third stiffening plate 32 are disposed, so that when the electronic device 1000 falls, the display 10 is not likely to fail due to the impact stress generated during the fall.

For example, a material of the second stiffening plate 31 may be steel, copper, aluminum, or a titanium alloy.

For example, a thickness of the second stiffening plate 31 ranges from 0.01 cm to 0.05 cm. The second stiffening plate 31 occupies less space of the electronic device 1000 in a thickness direction. This facilitates thinning of the electronic device 1000.

For example, a hardness of the second stiffening plate 31 is greater than 50 HB. The second stiffening plate 31 has sufficient strength to support the display 10.

For example, the second stiffening plate 31 and the first stiffening plate 30 may be spaced apart. **In** this case, a gap may exist between the first stiffening plate 30 and the second stiffening plate 31. **In** this way, in a process of folding and unfolding the electronic device 1000, bending stress of the display module 100 can be reduced, the anti-extrusion capability of the display 10 can be improved, and the display module 100 is not likely to be damaged due to local stress concentration. **In** addition, in the process of folding and unfolding the electronic device 1000, a rebound force of the display module 100 can be reduced, and opening and closing experience of the user can be improved.

It may be understood that, for a disposing manner of the third stiffening plate 32 and a connection manner of the third stiffening plate 32 and the first stiffening plate 30, refer to the second stiffening plate 31 and a connection manner of the second stiffening plate 31 and the first stiffening plate 30. Details are not described herein again.

In a fourth implementation, technical content that is the same as that in the first implementation to the third implementation is not described again.

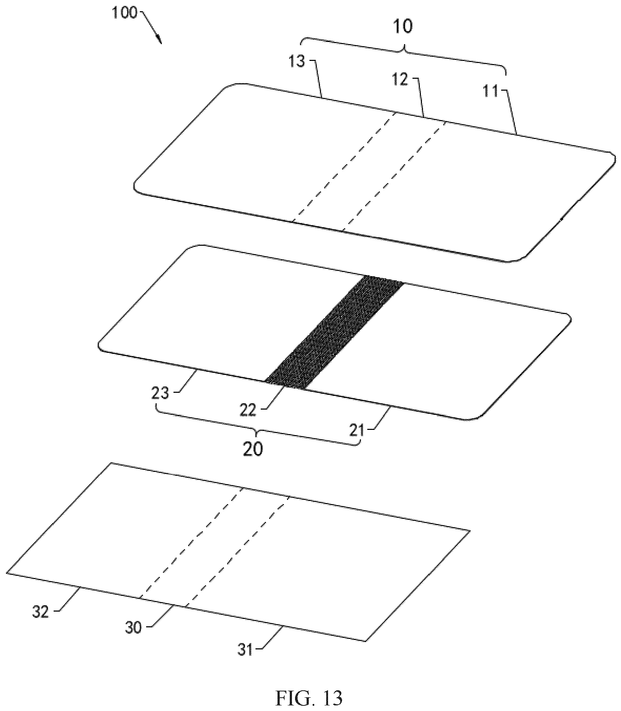

FIG. 13 is a diagram of a structure of still another implementation of the display module 100 shown in FIG. 5.

As shown in FIG. 13, the second stiffening plate 31 is connected to the first stiffening plate 30. In this way, the first stiffening plate 30 and the second stiffening plate 31 may form an integral structure. The first stiffening plate 30 and the second stiffening plate 31 can well improve the anti-extrusion capability and the anti-impact capability of the display module 100. In FIG. 13, the first stiffening plate 30 and the second stiffening plate 31 are schematically distinguished by dashed lines.

For example, the second stiffening plate 31 may be fastened to two sides of the first stiffening plate 30 in a bonding, welding, or riveting manner. In another implementation, the second stiffening plate 31 and the first stiffening plate 30 may alternatively be an integrally formed structural member. In this way, structures of the first stiffening plate 30 and the second stiffening plate 31 are simple, and production costs are low.

It may be understood that, although it is only described that the second stiffening plate 31 may be connected to the first stiffening plate 30 in this implementation, FIG. 13 also shows that the third stiffening plate 32 is connected to the first stiffening plate 30. In this case, the second stiffening plate 31 and the third stiffening plate 32 may be respectively located on two sides of the first stiffening plate 30. It may be understood that, for a connection manner of the third stiffening plate 32 and the first stiffening plate 30, refer to a connection manner of the second stiffening plate 31 and the first stiffening plate 30. Details are not described herein again. In another implementation, the second stiffening plate 31 is connected to the first stiffening plate 30, or the third stiffening plate 32 is connected to the first stiffening plate 30.

In a fifth implementation, technical content that is the same as that in the first implementation to the fourth implementation is not described again.

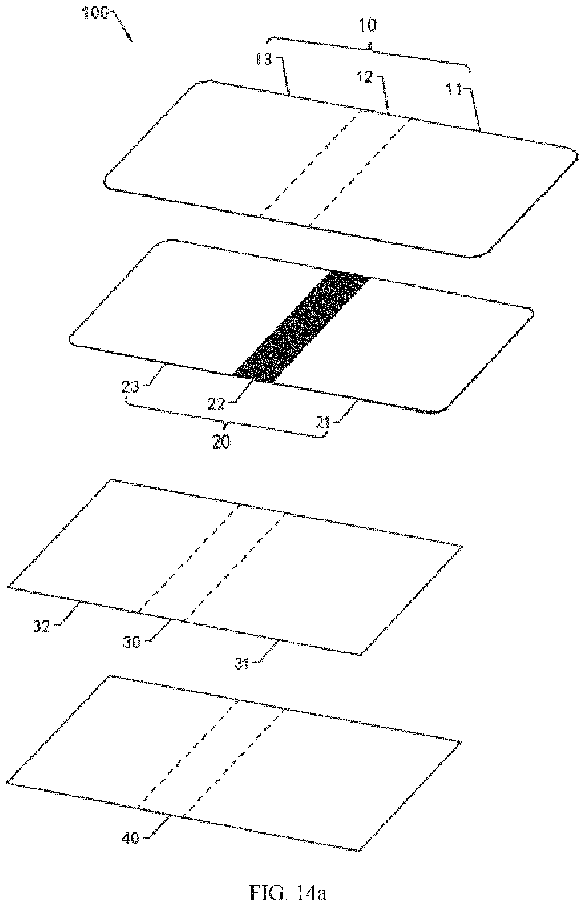

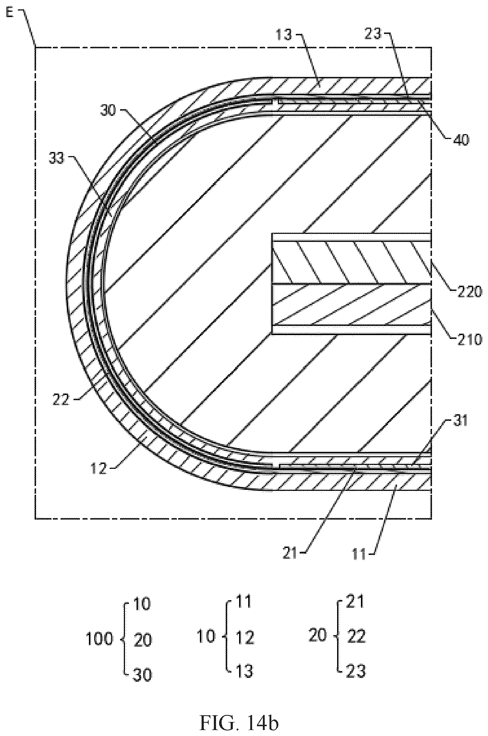

FIG. 14a is a diagram of a structure of yet another implementation of the display module 100 shown in FIG. 5. FIG. 14b is a partial sectional view of an implementation of the display module 100 shown in FIG. 14a in the closed state.

As shown in FIG. 14a and FIG. 14b, the display module 100 further includes a first buffer member 40. The first buffer member 40 is fastened to a side that is of the first stiffening plate 30 and that is away from the support member 20. The first buffer member 40 is further fastened to a side that is of the second stiffening plate 31 and that is away from the support member 20. The first buffer member 40 is further fastened to a side that is of the third stiffening plate 32 and that is away from the support member 20. In another implementation, the first buffer member 40 may be fastened to any one or two of the first stiffening plate 30, the second stiffening plate 31, and the third stiffening plate 32.

For example, the first buffer member 40 may be fastened, by using an OCA optical adhesive (not shown in the figure), a PVB adhesive, a foam adhesive, a combination material thereof, or the like, to a side that is of the first stiffening plate 30 and that is away from the display 10. The first buffer member 40 may be fastened, by using an OCA optical adhesive (not shown in the figure), a PVB adhesive, a foam adhesive, a combination material thereof, or the like, to a side that is of the second stiffening plate 31 and that is away from the display 10. The first buffer member 40 may be fastened, by using an OCA optical adhesive (not shown in the figure), a PVB adhesive, a foam adhesive, a combination material thereof, or the like, to a side that is of the third stiffening plate 32 and that is away from the display 10.

It may be understood that, regardless of whether the display module 100 is in an open state or a closed state, the display 10 is exposed relative to the housings. In this way, when the electronic device 1000 falls, the display 10 is more likely to be damaged due to impact. In addition, due to intersection of extrusion stress and impact stress on the display 10, the reliability of the display 10 is poor. However, in this implementation, the first buffer member 40 is disposed, so that the first buffer member 40 may play a buffering role when the electronic device 1000 falls. The display 10 is not likely to fail due to the impact stress generated during the fall. This reduces a risk of damage to the display 10. In addition, the first buffer member 40 may further improve the anti-extrusion capability of the display module 100. In the process of folding and unfolding the electronic device 1000, the first bending portion 12 of the display 10 is not likely to be damaged due to extrusion stress.

For example, a material of the first buffer member 40 may be a polymer material, for example, thermoplastic polyurethanes (Thermoplastic polyurethanes, TPU), a thermoplastic elastomer (Thermoplastic Elastomer, TPE), foam, or rubber. The material may alternatively be Mylar, a non-Newtonian fluid, or the like. The first buffer member 40 has good flexibility.

It may be understood that, in this implementation, because the first buffer member 40 is disposed at the bottom of the first stiffening plate 30, the second stiffening plate 31, and the third stiffening plate 32, the first stiffening plate 30, the second stiffening plate 31, and the third stiffening plate 32 may be connected to the first folding mechanism 300 (refer to FIG. 4) by using the first buffer member 40. Details are not described herein again.

In a sixth implementation, technical content that is the same as that in the first implementation to the fourth implementation is not described again.

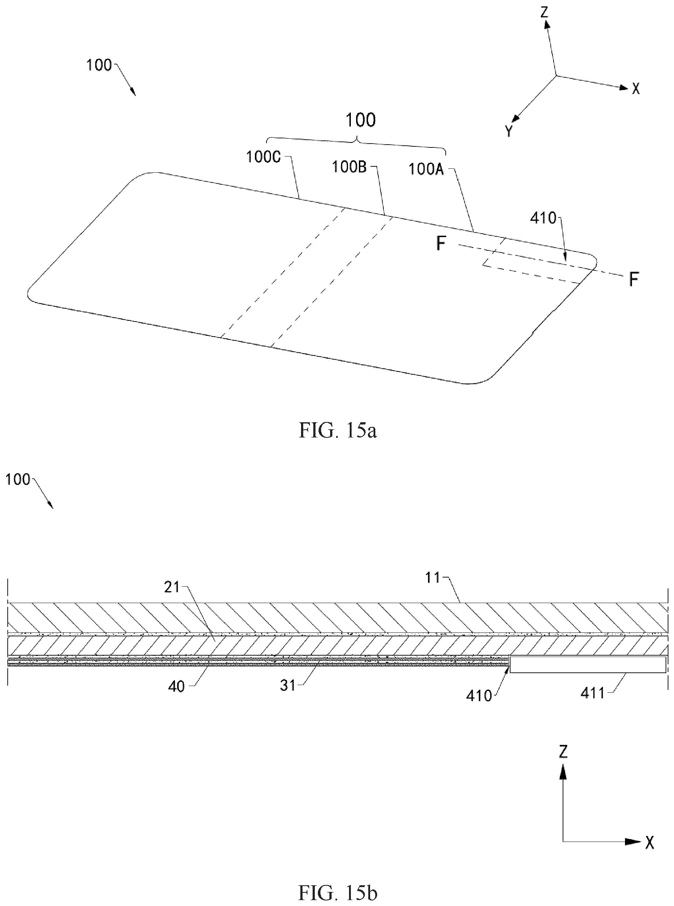

FIG. 15a is a diagram of a structure of still yet another implementation of the display module 100 shown in FIG. 5. FIG. 15b is a partial sectional view of an implementation of the display module 100 shown in FIG. 15a in an open state at an F-F line.

As shown in FIG. 15a and FIG. 15b, the display module 100 includes an avoidance groove 410. An opening of the avoidance groove 410 is located on a surface that is of the first buffer member 40 and that is away from the second stiffening plate 31. The avoidance groove 410 runs through the second stiffening plate 31 and the first buffer member 40.

The electronic device 1000 includes an electronic element 411. The electronic element 411 may be fastened to the first housing 210 (refer to FIG. 4). At least a part of the electronic element 411 may be located in the avoidance groove 410. That is, the avoidance groove 410 may be used to dispose the electronic element 411. For example, the electronic element 411 may be a chip, a capacitor, a camera, a motor, a speaker, a microphone, or the like.

In this implementation, the display module 100 is provided with the avoidance groove 410, and some electronic elements 411 of the electronic device 1000 are disposed in the avoidance groove 410, so that a mounting region may be provided for these electronic elements 411. In addition, in the thickness direction of the electronic device 1000, an overlapping region exists between the electronic elements 411 and the display module 100, so that thinning of the electronic device 1000 is facilitated, and carrying experience of the user is improved.

The foregoing specifically describes several implementations of the display module 100 and the electronic device 1000 with reference to related accompanying drawings. The following further specifically describes several implementations of the display module 100 and the electronic device 1000 with reference to related accompanying drawings. It may be understood that the foregoing several implementations are described by using the two-fold electronic device 1000 as an example. The following specifically uses a multi-fold electronic device 1000 as an example for description. The multi-fold electronic device 1000 may be an electronic device 1000 having three folds or more.

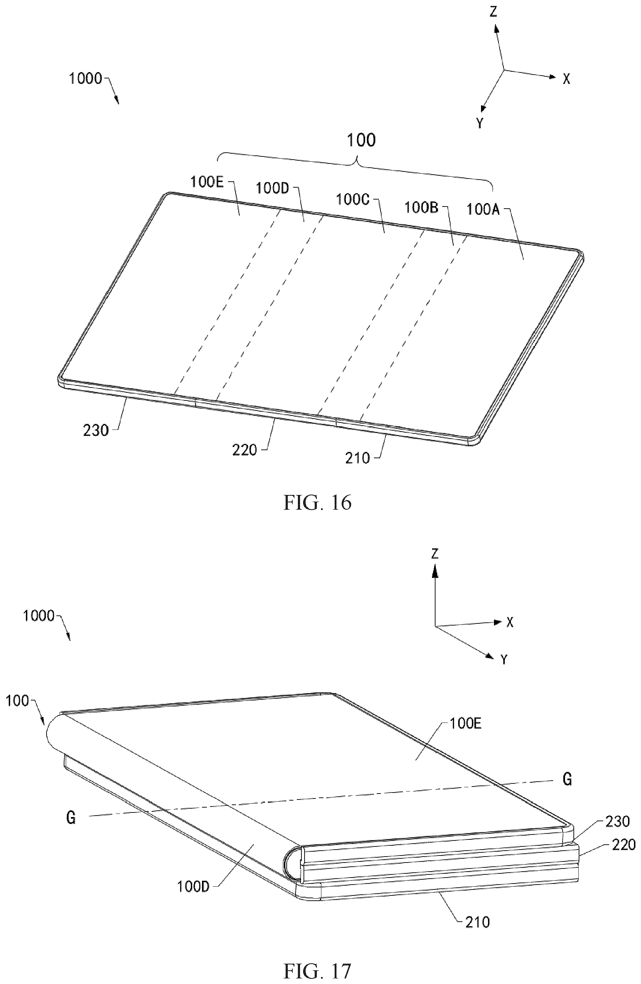

FIG. 16 is a diagram of a structure of another implementation of an electronic device 1000 in an open state according to this application. FIG. 17 is a diagram of a structure of an implementation of the electronic device 1000 shown in FIG. 16 in a closed state.

As shown in FIG. 16 and FIG. 17, the electronic device 1000 may be a foldable device like a mobile phone, a tablet computer, a personal computer, a notebook computer, a vehicle-mounted device, or a wearable device. In the embodiment shown in FIG. 16, the electronic device 1000 is described by using a mobile phone as an example.

For ease of description, for example, a thickness direction of the electronic device 1000 is defined as a Z-axis direction, and an extension direction of a rotation axis of the electronic device 1000 is defined as a Y-axis direction, that is, a width direction of the electronic device 1000 is defined as the Y-axis direction. A direction perpendicular to the Y-axis direction and the Z-axis direction is an X-axis direction, that is, a length direction of the electronic device 1000 is an X-axis. It may be understood that a coordinate system of the electronic device 1000 may alternatively be flexibly set based on a specific requirement. In this implementation, when the direction of the rotation axis of the electronic device 1000 is the Y-axis direction, the electronic device 1000 may be unfolded or folded in the Y-axis direction. In this way, when the electronic device 1000 is in the closed state, a size of the electronic device 1000 in the X-axis direction is reduced.

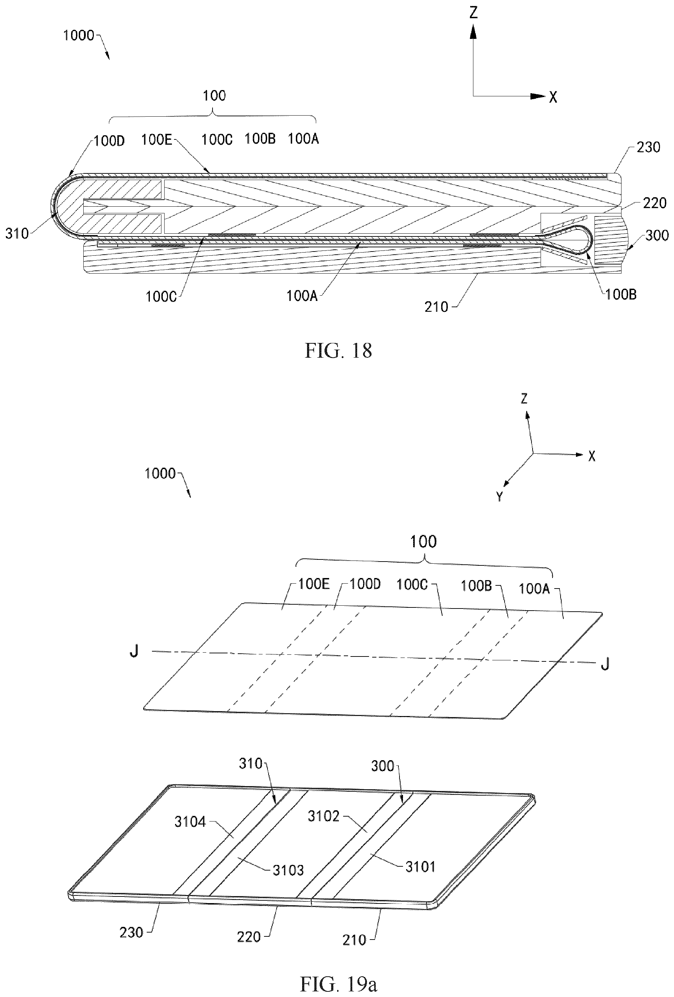

FIG. 18 is a partial sectional view of an implementation of the electronic device 1000 shown in FIG. 17 at a G-G line.

As shown in FIG. 16 to FIG. 18, the electronic device 1000 includes a display module 100, a first housing 210, a second housing 220, a third housing 230, a first folding mechanism 300, and a second folding mechanism 310. The first folding mechanism 300 is connected between the first housing 210 and the second housing 220. The first folding mechanism 300 is configured to unfold or fold the first housing 210 and the second housing 220 relative to each other. The second folding mechanism 310 is connected between the second housing 220 and the third housing 230. The second folding mechanism 310 is configured to unfold or fold the second housing 220 and the third housing 230 relative to each other.

It may be understood that, as shown in FIG. 16, when the first housing 210, the second housing 220, and the third housing 230 are unfolded relative to each other to a flattened state, the electronic device 1000 is in a flattened state, and the first housing 210, the second housing 220, and the third housing 230 may be 180°apart. In another embodiment, the first housing 210, the second housing 220, and the third housing 230 may alternatively be apart at another angle, for example, 165°, 177°, or 185°.

As shown in FIG. 17, when the first housing 210, the second housing 220, and the third housing 230 are folded relative to each other to a closed state, the electronic device 1000 is in the closed state, the first housing 210 and the second housing 220 are close to each other, and the second housing 220 and the third housing 230 may be close to each other. In this case, the first housing 210, the second housing 220, and the third housing 230 may be arranged in the Z-axis direction.

As shown in FIG. 16 and FIG. 18, the display module 100 includes a first portion 100A, a second portion 100B, a third portion 100C, a fourth portion 100D, and a fifth portion 100E that are sequentially connected. The second portion 100B is connected between the first portion 100A and the third portion 100C. The third portion 100C is connected between the second portion 100B and the fourth portion 100D. The fourth portion 100D is connected between the third portion 100C and the fifth portion 100E. For example, in FIG. 16, an example in which the first portion 100A, the second portion 100B, the third portion 100C, the fourth portion 100D, and the fifth portion 100E are arranged in the X-axis direction is used for illustration.

As shown in FIG. 16 and FIG. 18, the first portion 100A of the display module 100 may be fastened to the first housing 210. The third portion 100C may be fastened to the second housing 220. The fifth portion 100E of the display module 100 may be fastened to the third housing 230. The second portion 100B may be disposed opposite to the first folding mechanism 300. The fourth portion 100D may be disposed opposite to the second folding mechanism 310. It may be understood that, when the first folding mechanism 300 unfolds or folds the first housing 210 and the second housing 220 relative to each other, the first housing 210 may drive the first portion 100A of the display module 100 to be unfolded or folded, and the second housing 220 may drive the third portion 100C of the display module 100 to be unfolded or folded. In this case, the second portion 100B of the display module 100 is bent. When the second folding mechanism 310 unfolds or folds the second housing 220 and the third housing 230 relative to each other, the second housing 220 may drive the third portion 100C of the display module 100 to be unfolded or folded, and the second housing 220 may drive the first portion 100A of the display module 100 to be unfolded or folded. In this case, the second portion 100B of the display module 100 is bent.

As shown in FIG. 16, when the electronic device 1000 is in the open state, the display module 100 may be in a flattened state. For example, the first portion 100A, the second portion 100B, the third portion 100C, the fourth portion 100D, and the fifth portion 100E of the display module 100 may be approximately 180° apart (a slight deviation, for example, 165°, 177°, or 185°, is allowed). In this case, the display module 100 has a large continuous display region. In other words, the display module 100 can implement large-screen display, so that user experience is good.

As shown in FIG. 17 and FIG. 18, when the electronic device 1000 is in the closed state, the display module 100 may be in a folded state. That is, the second portion 100B and the fourth portion 100D of the display module 100 are bent, the first portion 100A and the third portion 100C of the display module 100 are located between the first housing 210 and the second housing 220, and the fifth portion 100E of the display module 100 is located on a side that is of the third housing 230 and that is away from the second housing 220. That is, the second housing 220 and the third housing 230 are located between the third portion 100C and the fifth portion 100E. In this way, when the electronic device 1000 is in the closed state, the first housing 210 is folded relative to the second housing 220 and the third housing 230, the second housing 220 and the third housing 230 overlap with each other, the display module 100 is folded, and a size of the electronic device 1000 in an X-Y direction is reduced. This facilitates storage of the electronic device 1000. In addition, a part or all of the display module 100 may be used for display. An area of the display module 100 is small. This helps reduce a probability that the display module 100 is damaged.

It may be understood that, when the electronic device 1000 is in the closed state, the first portion 100A and the third portion 100C of the display module 100 are accommodated between the first housing 210 and the second housing 220. In this case, the second portion 100B of the display module 100 is an inward-bending structure. The fourth portion 100D and the fifth portion 100E of the display module 100 are exposed relative to the third housing 230, that is, exposed to the outside. In this case, the fourth portion 100D of the display module 100 is an outward-bending structure.

FIG. 19a is a partial exploded diagram of an implementation of the electronic device 1000 shown in FIG. 16.

As shown in FIG. 19a, the first folding mechanism 300 includes a first door board 3101 and a second door board 3102. The second folding mechanism 310 includes a third door board 3103 and a fourth door board 3104. For a disposing manner of the first folding mechanism 300 and the second folding mechanism 310, refer to the disposing manner of the first folding mechanism 300 in the implementation shown in FIG. 4. Details are not described herein again.

It may be understood that, because there is a gap between the first door board 3101 and the second door board 3102, and between the third door board 3103 and the fourth door board 3104, when the electronic device 1000 is in the flattened state, a position that is in the display module 100 and that is disposed directly opposite to the gap is in an unsupported state. In this case, when a user touches the position, the display module 100 is likely to be dented at the position. That is, an anti-extrusion capability and an anti-impact capability of the display module 100 are poor. In addition, in some solutions, some avoidance holes or avoidance grooves are provided on the first door board 3101, the second door board 3102, the third door board 3103, and the fourth door board 3104. Therefore, when the electronic device 1000 is in the flattened state, a position that is in the display module 100 and that is disposed directly opposite to the avoidance hole or the avoidance groove is in an unsupported state. In this case, when the user touches the position, the display module 100 is also likely to be dented at the position. That is, the anti-extrusion capability and the anti-impact capability of the display module 100 are poor. However, in this application, the display module 100 having a good anti-extrusion capability and a good anti-impact capability is disposed, so that when the electronic device 1000 is in the flattened state, the position that is in the display module 100 and that is disposed directly opposite to the gap still has a good anti-extrusion capability and a good anti-impact capability, and the position that is in the display module 100 and that is disposed directly opposite to the avoidance hole or the avoidance groove also still has a good anti-extrusion capability and a good anti-impact capability.

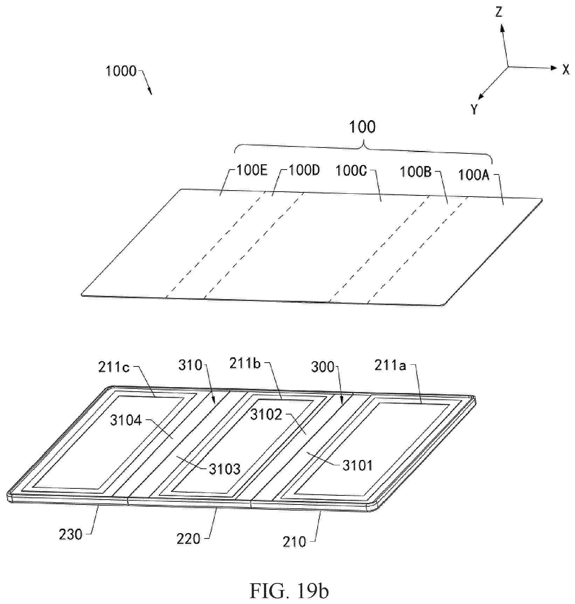

FIG. 19b is a partial exploded diagram of another implementation of the electronic device 1000 shown in FIG. 16.

As shown in FIG. 19a and FIG. 19b, the first portion 100A, the third portion 100C, and the fifth portion 100E of the display module 100 may be respectively fastened to the first housing 210, the second housing 220, and the third housing 230.

For example, the first portion 100A, the third portion 100C, and the fifth portion 100E of the display module 100 may be respectively fastened to the first housing 210, the second housing 220, and the third housing 230 by using an adhesive 211a, an adhesive 211b, and an adhesive 211C. The adhesive 211a, the adhesive 211b, and the adhesive 211C may all be annular. In this way, the electronic device 1000 may provide more regions for disposing other electronic elements, such as a chip, a capacitor, a camera, a motor, a speaker, and a microphone.

In this implementation, the adhesive 211a, the adhesive 211b, and the adhesive 211C may be an OCA optical adhesive, a PVB adhesive, a foam adhesive, a combination material thereof, or the like.

The following specifically describes a structure of the display module 100 with reference to related accompanying drawings.

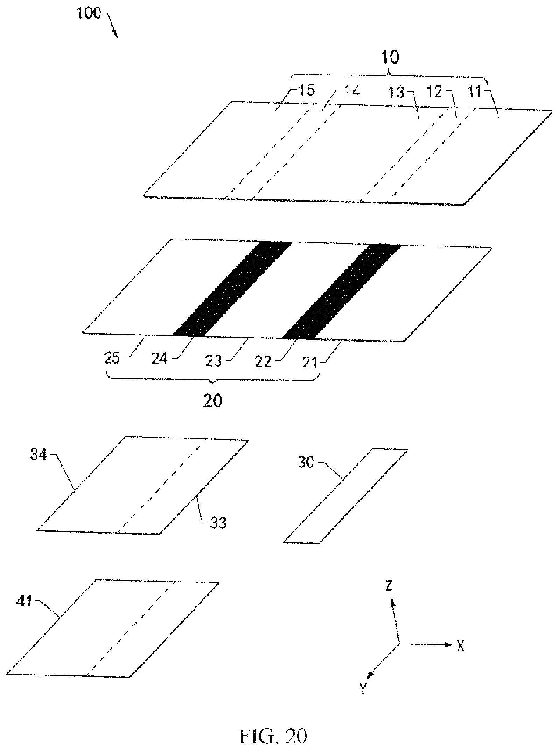

FIG. 20 is a partial exploded diagram of an implementation of the display module 100 shown in FIG. 19a.

As shown in FIG. 20, the display module 100 includes a display 10, a support member 20, a first stiffening plate 30, a fourth stiffening plate 33, and a fifth stiffening plate 34. The display 10 is configured to display an image, a text, a video, and the like. The display 10 may be a flexible display. The fourth stiffening plate 33 and the fifth stiffening plate 34 form an integral structure. For a connection manner of the fourth stiffening plate 33 and the fifth stiffening plate 34, refer to the foregoing connection manner of the first stiffening plate 30 and the second stiffening plate 31. Details are not described herein again. In FIG. 20, the fourth stiffening plate 33 and the fifth stiffening plate 34 are schematically distinguished by dashed lines.

For example, the display 10 may include structures such as a back film, a display panel, a polarizer, and a protective cover (not shown in the figure). The display panel is configured to display an image, a video, and the like. In an implementation, the display 10 may further include a touchpad or the like.

As shown in FIG. 20, the display 10 includes a first non-bending portion 11, a first bending portion 12, a second non-bending portion 13, a second bending portion 14, and a third non-bending portion 15 that are sequentially connected. The first bending portion 12 is connected between the first non-bending portion 11 and the second non-bending portion 13. The second bending portion 14 is connected between the second non-bending portion 13 and the third non-bending portion 15. The first non-bending portion 11 is a part of the first portion 100A (refer to FIG. 19a) of the display module 100. The first bending portion 12 is a part of the second portion 100B (refer to FIG. 19a). The second non-bending portion 13 is a part of the third portion 100C (refer to FIG. 19a). The second bending portion 14 is a part of the fourth portion 100D (refer to FIG. 19a). The third non-bending portion 15 is a part of the fifth portion 100E (refer to FIG. 19a). It may be understood that, in FIG. 17, the first non-bending portion 11, the first bending portion 12, the second non-bending portion 13, the second bending portion 14, and the third non-bending portion 15 are schematically distinguished by dashed lines.

As shown in FIG. 20, when the electronic device 1000 is in the open state, the first non-bending portion 11, the first bending portion 12, the second non-bending portion 13, the second bending portion 14, and the third non-bending portion 15 of the display 10 are approximately 180° apart (a slight deviation, for example, 165°, 177°, or 185°, is allowed).

As shown in FIG. 20, the support member 20 includes a first support portion 21, a second support portion 22, a third support portion 23, a fourth support portion 24, and a fifth support portion 25 that are sequentially connected. In other words, the second support portion 22 is connected between the first support portion 21 and the third support portion 23. The third support portion 23 is connected between the second support portion 22 and the fourth support portion 24. The fourth support portion 24 is connected between the third support portion 23 and the fifth support portion 25. The first support portion 21 is a part of the first portion 100A (refer to FIG. 19a) of the display module 100. The second support portion 22 is a part of the second portion 100B (refer to FIG. 19a). The third support portion 23 is a part of the third portion 100C (refer to FIG. 19a). The fourth support portion 24 is a part of the fourth portion 100D (refer to FIG. 19a). The fifth support portion 25 is a part of the fifth portion 100E (refer to FIG. 19a). It may be understood that, in FIG. 17, the first support portion 21, the second support portion 22, and the third support portion 23 are schematically distinguished by dashed lines.

It may be understood that the first support portion 21, the second support portion 22, the third support portion 23, the fourth support portion 24, and the fifth support portion 25 are an integral structure. That is, the support member 20 is an integrally formed structural member. In this case, the first support portion 21, the second support portion 22, the third support portion 23, the fourth support portion 24, and the fifth support portion 25 are more firmly connected. In addition, the first support portion 21, the second support portion 22, the third support portion 23, the fourth support portion 24, and the fifth support portion 25 are formed in fewer steps, so that costs of preparing the support member 20 can be reduced. In another implementation, the first support portion 21, the second support portion 22, the third support portion 23, the fourth support portion 24, and the fifth support portion 25 may alternatively be formed by welding or connected by snap-fitting.

For example, the second support portion 22 may be provided with first through holes 2211 and/or second grooves (not shown in the figure). The fourth support portion 24 may be provided with second through holes 2411 and/or second grooves (not shown in the figure). For a disposing manner of the first through holes 2211 and a disposing manner of the second through holes 2411, refer to the disposing manner of the first through holes 2211 in the implementation shown in FIG. 6. Details are not described herein again.

For example, a material of the support member 20 may be a composite material like carbon fiber or glass fiber.

In another implementation, the material of the support member 20 may alternatively be a metal material like stainless steel or a titanium alloy.

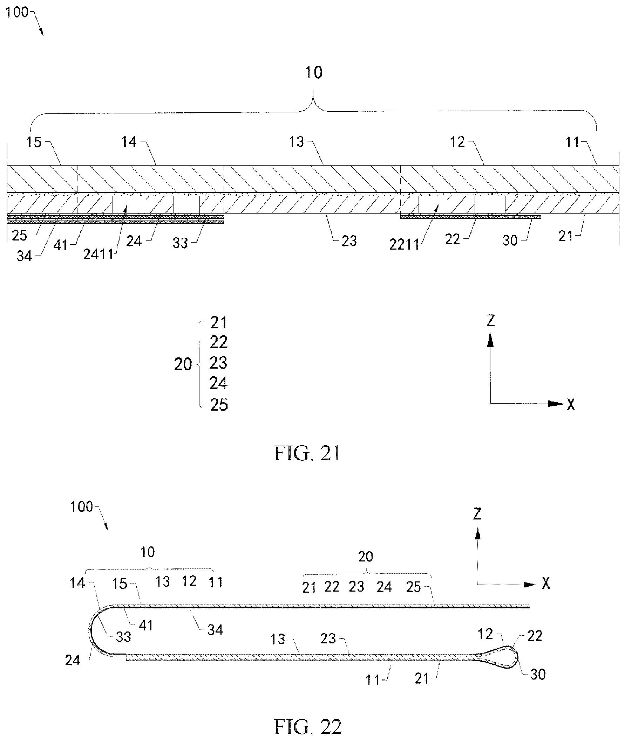

FIG. 21 is a partial sectional view of an implementation of the display module 100 shown in FIG. 19a at a J-J line.

As shown in FIG. 21, the first support portion 21 is connected to the first non-bending portion 11 of the display 10. The second support portion 22 is connected to the first bending portion 12 of the display 10. The third support portion 23 is connected to the second non-bending portion 13. The fourth support portion 24 is connected to the second bending portion 14. The fifth support portion 25 is connected to the third non-bending portion 15.

For example, the first support portion 21 may be connected to the first non-bending portion 11 of the display 10 by using an adhesive. The second support portion 22 may be connected to the first bending portion 12 of the display 10 by using an adhesive. The third support portion 23 may be connected to the second non-bending portion 13 by using an adhesive. The fourth support portion 24 may be connected to the second bending portion 14 by using an adhesive. The fifth support portion 25 may be connected to the third non-bending portion 15 by using an adhesive. For example, the adhesive may be an OCA optical adhesive, a PVB adhesive, a foam adhesive, or a combination material thereof.

As shown in FIG. 21, when the electronic device 1000 is in the open state, the first support portion 21, the second support portion 22, the third support portion 23, the fourth support portion 24, and the fifth support portion 25 are approximately 180° apart (a slight deviation, for example, 165°, 177°, or 185°, is allowed). The first support portion 21 may be configured to support the first non-bending portion 11 of the display 10. The second support portion 22 may be configured to support the first bending portion 12 of the display 10. The third support portion 23 may be configured to support the second non-bending portion 13 of the display 10. The fourth support portion 24 may be configured to support the second bending portion 14 of the display 10. The fifth support portion 25 may be configured to support the third non-bending portion 15 of the display 10.

FIG. 22 is a sectional view of an implementation of the display module 100 shown in FIG. 19a in the folded state.

As shown in FIG. 22, when the electronic device 1000 is in the closed state, the first bending portion 12 and the second bending portion 14 of the display 10 are bent, so that the first non-bending portion 11, the second non-bending portion 13, and the third non-bending portion 15 may be stacked. The second non-bending portion 13 is located between the first non-bending portion 11 and the third non-bending portion 15. The first non-bending portion 11 and the second non-bending portion 13 partially or completely overlap. The second non-bending portion 13 and the third non-bending portion 15 partially or completely overlap. FIG. 22 shows that the entire display 10 is approximately "S"-shaped.

As shown in FIG. 20 to FIG. 22, the first stiffening plate 30 is fastened to a side that is of the support member 20 and that is away from the first bending portion 12 and covers the first through holes 2211. When the first housing 210 (refer to FIG. 19a) and the second housing 220 (refer to FIG. 19a) are unfolded or folded relative to each other, both the support member 20 and the first stiffening plate 30 are bendable. For a manner of connecting the first stiffening plate 30 to the support member 20, refer to the foregoing manner of connecting the first stiffening plate 30 to the support member 20. Details are not described herein again.

In this implementation, the first stiffening plate 30 is fastened to both the first door board 3101 (refer to FIG. 19a) and the second door board 3102 (refer to FIG. 19a). For a manner of connecting the first stiffening plate 30 to the first door board 3101 (refer to FIG. 19a) and the second door board 3102 (refer to FIG. 19a), refer to the manner of connecting the first stiffening plate 30 to the first door board 3101 and the second door board 3102 in the implementation shown in FIG. 9. Details are not described herein again.

For a thickness, a hardness, and a material of the first stiffening plate 30, refer to the thickness, the hardness, and the material of the first stiffening plate 30 described above. Details are not described herein again.

As shown in FIG. 20 to FIG. 22, the fourth stiffening plate 33 is fastened to a side that is of the support member 20 and that is away from the second bending portion 14 and covers the second through holes 2411. When the second housing 220 (refer to FIG. 19a) and the third housing 230 (refer to FIG. 19a) are unfolded or folded relative to each other, both the support member 20 and the fourth stiffening plate 33 are bendable. For a manner of connecting the fourth stiffening plate 33 to the support member 20, refer to the foregoing manner of connecting the first stiffening plate 30 to the support member 20. Details are not described herein again.

In this implementation, the fourth stiffening plate 33 is fastened to both the third door board 3103 (refer to FIG. 19a) and the fourth door board 3104 (refer to FIG. 19a). For a manner of connecting the fourth stiffening plate 33 to the third door board 3103 (refer to FIG. 19a) and the fourth door board 3104 (refer to FIG. 19a), refer to the foregoing manner of connecting the first stiffening plate 30 to the first door board 3101 and the second door board 3102. Details are not described herein again.

For a thickness, a hardness, and a material of the fourth stiffening plate 33, refer to the thickness, the hardness, and the material of the first stiffening plate 30 described above. Details are not described herein again.

As shown in FIG. 20 to FIG. 22, the fifth stiffening plate 34 is located on a side that is of the support member 20 and that is away from the display 10. The fifth stiffening plate 34 may be fastened to the fifth support portion 25 of the support member 20. For a manner of connecting the fifth stiffening plate 34 to the support member 20, refer to the foregoing manner of connecting the second stiffening plate 31 to the support member 20. Details are not described herein again.

For a material, a thickness, and a hardness of the fifth stiffening plate 34, refer to the material, the thickness, and the hardness of the second stiffening plate 31 described above. Details are not described herein again.

As shown in FIG. 20 to FIG. 22, the display module 100 further includes a second buffer member 41. The second buffer member 41 is fastened to a side that is of the fourth stiffening plate 33 and that is away from the support member 20. The second buffer member 41 is further fastened to a side that is of the fifth stiffening plate 34 and that is away from the support member 20. In another implementation, the second buffer member 41 may be fastened to one or both of the fourth stiffening plate 33 and the fifth stiffening plate 34.

For a manner of connecting the second buffer member 41 to the fourth stiffening plate 33, refer to the foregoing manner of connecting the first buffer member 40 to the first stiffening plate 30. Details are not described herein again. For a manner of connecting the second buffer member 41 to the fifth stiffening plate 34, refer to the foregoing manner of connecting the first buffer member 40 to the second stiffening plate 31. Details are not described herein again.

For a material of the second buffer member 41, refer to the material of the first buffer member 40 described above. Details are not described herein again.

It may be understood that, in this implementation, because the second buffer member 41 is disposed at the bottom of the fourth stiffening plate 33 and the fifth stiffening plate 34, the fourth stiffening plate 33 and the fifth stiffening plate 34 may be connected to the second folding mechanism 310 (refer to FIG. 19a) by using the second buffer member 41. Details are not described herein again.

In another implementation, the display module 100 may alternatively not include the second buffer member 41. In this case, a size of the electronic device 1000 in the thickness direction is small. This facilitates implementation of thinning of the electronic device 1000.

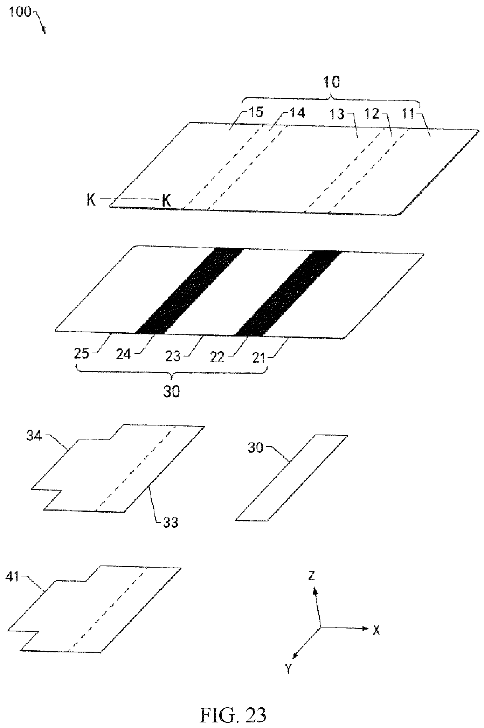

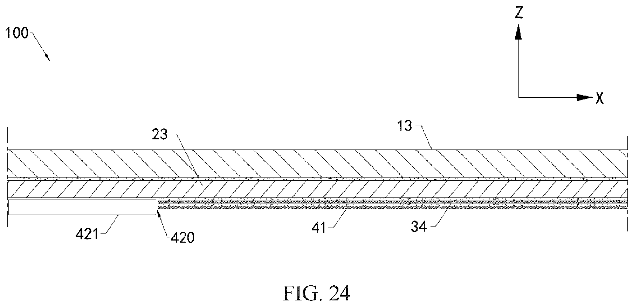

FIG. 23 is a diagram of a structure of another implementation of the display module 100 shown in FIG. 20. FIG. 24 is a partial sectional view of an implementation of the display module 100 shown in FIG. 23 in the open state at a K-K line.

As shown in FIG. 23 and FIG. 24, the display module 100 includes an avoidance groove 420. An opening of the avoidance groove 420 is located on a surface of the second buffer member 41. The avoidance groove 420 runs through the fourth stiffening plate 33 and the second buffer member 41.

The electronic device 1000 includes an electronic element 421. The electronic element 421 may be fastened to the first housing 210 (refer to FIG. 16). At least a part of the electronic element 421 may be located in the avoidance groove 420. That is, the avoidance groove 420 may be used to dispose the electronic element 421. For example, the electronic element 421 may be a chip, a capacitor, a camera, a motor, a speaker, a microphone, or the like.

It may be understood that the display module 100 is provided with the avoidance groove 420, and some electronic elements 421 of the electronic device 1000 are disposed in the avoidance groove 420, so that a mounting region may be provided for these electronic elements 421. In addition, in the thickness direction of the electronic device 1000, an overlapping region exists between the electronic elements 421 and the display module 100, so that thinning of the electronic device 1000 is facilitated, and carrying experience of the user is improved.

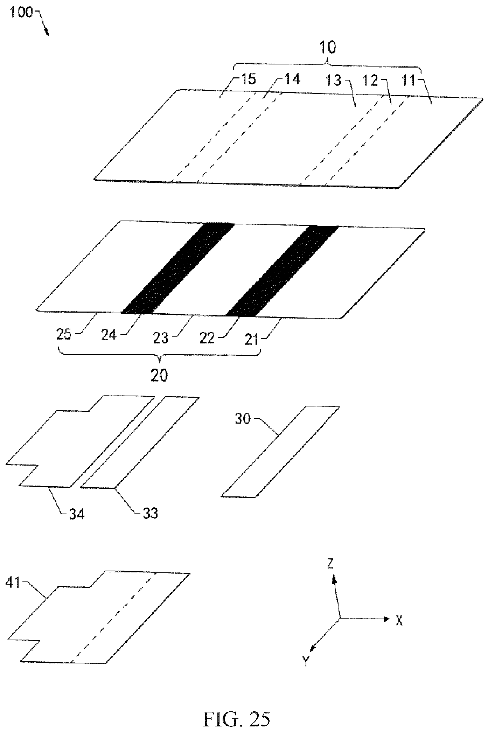

FIG. 25 is a diagram of a structure of still another implementation of the display module 100 shown in FIG. 20.

As shown in FIG. 25, the fourth stiffening plate 33 and the fifth stiffening plate 34 may be spaced apart. In this case, a gap may exist between the fourth stiffening plate 33 and the fifth stiffening plate 34. **In** this way, in the process of folding and unfolding the electronic device 1000, bending stress of the display module 100 can be reduced, the anti-extrusion capability of the display 10 can be improved, and the display module 100 is not likely to be damaged due to local stress concentration. In addition, in the process of folding and unfolding the electronic device 1000, a rebound force of the display module 100 can be reduced, and opening and closing experience of the user can be improved.

The foregoing specifically describes several implementations of the tri-fold electronic device 1000 and the display module 100 with reference to related accompanying drawings. The following further specifically describes other several implementations of the tri-fold electronic device 1000 and the display module 100 with reference to related accompanying drawings.

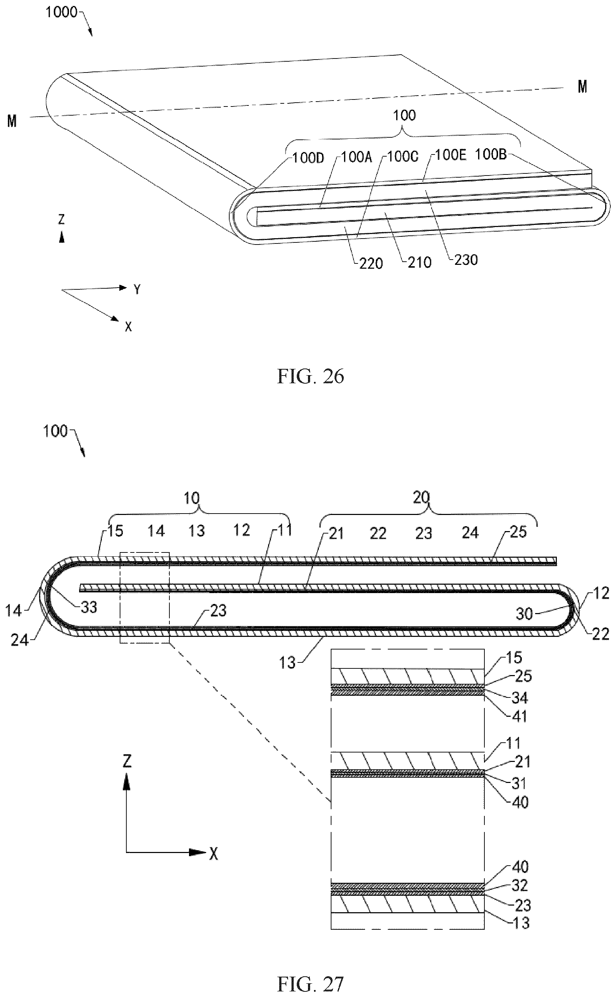

FIG. 26 is a diagram of still another implementation of an electronic device 1000 in a closed state according to this application.

As shown in FIG. 26, the electronic device 1000 includes a first housing 210, a second housing 220, a third housing 230, and a display module 100. For a disposing manner and a connection relationship of the first housing 210, the second housing 220, and the third housing 230, refer to the disposing manner and the connection relationship of the first housing 210, the second housing 220, and the third housing 230 that are described above. For a disposing manner and a connection relationship of the display module 100, refer to the disposing manner and the connection relationship of the display module 100 described above. Specifically, technical content that is the same as the foregoing is not described herein again.

As shown in FIG. 26, when the electronic device 1000 is in the closed state, the first housing 210, the second housing 220, and the third housing 230 may be folded relative to each other. The second housing 220, the first housing 210, and the third housing 230 may be sequentially arranged and disposed in a Z-axis direction, and the first housing 210 is located between the second housing 220 and the third housing 230. The display module 100 may be in a folded state. That is, a second portion 100B and a fourth portion 100D of the display module 100 are bent. A first portion 100A, the second portion 100B, a third portion 100C, the fourth portion 100D, and a fifth portion 100E of the display module 100 are all exposed outside the housings. The display module 100 may be configured to display an image in a large area, so that user experience can be improved.

It may be understood that, when the electronic device 1000 is in the closed state, the first portion 100A, the second portion 100B, the third portion 100C, the fourth portion 100D, and the fifth portion 100E of the display module 100 are all exposed outside the housings. In this case, both the second portion 100B and the fourth portion 100D of the display module 100 are outward-bending structures.

FIG. 27 is a partial sectional view of an implementation of the display module 100 shown in FIG. 26 at an M-M line.

As shown in FIG. 26 and FIG. 27, the display module 100 includes a display 10, a support member 20, a first stiffening plate 30, a second stiffening plate 31, a third stiffening plate 32, a fourth stiffening plate 33, and a fifth stiffening plate 34.

For example, the display 10 includes a first non-bending portion 11, a first bending portion 12, a second non-bending portion 13, a second bending portion 14, and a third non-bending portion 15 that are sequentially connected. For a disposing manner and a connection manner of the first non-bending portion 11, the first bending portion 12, the second non-bending portion 13, the second bending portion 14, and the third non-bending portion 15, refer to the disposing manner and the connection manner of the first non-bending portion 11, the first bending portion 12, the second non-bending portion 13, the second bending portion 14, and the third non-bending portion 15 that are described above. Details are not described herein again.

For example, the support member 20 includes a first support portion 21, a second support portion 22, a third support portion 23, a fourth support portion 24, and a fifth support portion 25 that are sequentially connected. For a disposing manner and a connection manner of the first support portion 21, the second support portion 22, the third support portion 23, the fourth support portion 24, and the fifth support portion 25, refer to the disposing manner and the connection manner of the first support portion 21, the second support portion 22, the third support portion 23, the fourth support portion 24, and the fifth support portion 25 that are described above. Details are not described herein again.

As shown in FIG. 27, the first stiffening plate 30, the second stiffening plate 31, the third stiffening plate 32, the fourth stiffening plate 33, and the fifth stiffening plate 34 are all located on a side that is of the support member 20 and that is away from the display 10. For a disposing manner of the first stiffening plate 30, the second stiffening plate 31, the third stiffening plate 32, the fourth stiffening plate 33, and the fifth stiffening plate 34, and a manner of connecting the first stiffening plate 30, the second stiffening plate 31, the third stiffening plate 32, the fourth stiffening plate 33, and the fifth stiffening plate 34 to the support member 20, refer to the manner of disposing the first stiffening plate 30, the second stiffening plate 31, the third stiffening plate 32, the fourth stiffening plate 33, and the fifth stiffening plate 34 that are described above and the manner of connecting the first stiffening plate 30, the second stiffening plate 31, the third stiffening plate 32, the fourth stiffening plate 33, and the fifth stiffening plate 34 to the support member 20. Details are not described herein again.

As shown in FIG. 27, the display module 100 further includes a first buffer member 40. For a disposing manner of the first buffer member 40 and a manner of connecting the first buffer member 40 to the first stiffening plate 30, the second stiffening plate 31, and the third stiffening plate 32, refer to the disposing manner of the first buffer member 40 described above and the manner of connecting the first buffer member 40 to the first stiffening plate 30, the second stiffening plate 31, and the third stiffening plate 32. Details are not described herein again.

It may be understood that, in this implementation, because the first buffer member 40 is disposed at the bottom of the first stiffening plate 30, the second stiffening plate 31, and the third stiffening plate 32, the first stiffening plate 30, the second stiffening plate 31, and the third stiffening plate 32 may be connected to the first folding mechanism 300 (refer to FIG. 19a) by using the first buffer member 40. Details are not described herein again.

As shown in FIG. 27, the display module 100 may further include a second buffer member 41. For a disposing manner of the second buffer member 41 and a manner of connecting the second buffer member 41 to the fourth stiffening plate 33 and the fifth stiffening plate 34, refer to the disposing manner of the second buffer member 41 described above and the manner of connecting the second buffer member 41 to the fourth stiffening plate 33 and the fifth stiffening plate 34. Details are not described herein again.

It may be understood that, in this implementation, because the second buffer member 41 is disposed at the bottom of the fourth stiffening plate 33 and the fifth stiffening plate 34, the fourth stiffening plate 33 and the fifth stiffening plate 34 may be connected to the second folding mechanism 310 (refer to FIG. 19a) by using the second buffer member 41. Details are not described herein again.

In an implementation, the display module 100 includes an avoidance groove (not shown in the figure). For a disposing manner of the avoidance groove, refer to the disposing manner of the avoidance groove 410 and/or the avoidance groove 420 described above. Details are not described herein again.

In this implementation, the electronic device 1000 includes an electronic element (not shown in the figure). The electronic element may be a chip, a capacitor, a camera, a motor, a speaker, a microphone, or the like. For a disposing manner of the electronic element, refer to the disposing manner of the electronic element 411 and/or the electronic element 421 described above. Details are not described herein again.

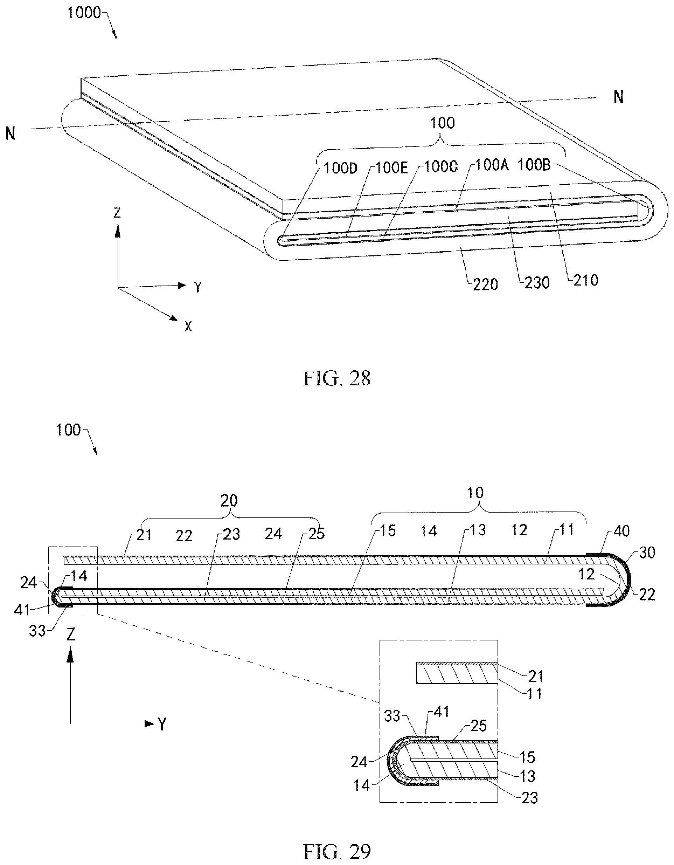

FIG. 28 is a diagram of yet another implementation of an electronic device 1000 in a closed state according to an embodiment of this application.

As shown in FIG. 28, the electronic device 1000 includes a first housing 210, a second housing 220, a third housing 230, and a display module 100. For a disposing manner and a connection relationship of the first housing 210, the second housing 220, and the third housing 230, refer to the disposing manner and the connection relationship of the first housing 210, the second housing 220, and the third housing 230 that are described above. For a disposing manner and a connection relationship of the display module 100, refer to the disposing manner and the connection relationship of the display module 100 described above. Specifically, technical content that is the same as the foregoing is not described herein again.

As shown in FIG. 28, when the electronic device 1000 is in the closed state, the first housing 210, the second housing 220, and the third housing 230 may be folded relative to each other. The second housing 220, the third housing 230, and the first housing 210 may be sequentially arranged and disposed in a Z-axis direction, and the third housing 230 is located between the first housing 210 and the second housing 220. The display module 100 may be in a folded state. That is, a second portion 100B and a fourth portion 100D of the display module 100 are bent. A first portion 100A of the display module 100 is located between the first housing 210 and the third housing 230. A third portion 100C and a fifth portion 100E of the display module 100 are located between the second housing 220 and the third housing 230. In this case, the first portion 100A, the second portion 100B, the third portion 100C, the fourth portion 100D, and the fifth portion 100E of the display module 100 are all protected by the housings. This helps reduce a probability that the display module 100 is damaged.

It may be understood that, when the electronic device 1000 is in the closed state, the first portion 100A, the second portion 100B, the third portion 100C, the fourth portion 100D, and the fifth portion 100E of the display module 100 are all accommodated among the first housing 210, the second housing 220, and the third housing 230. In this case, both the second portion 100B and the fourth portion 100D of the display module 100 are inward-bending structures.

FIG. 29 is a partial sectional view of an implementation of the display module 100 shown in FIG. 28 at an N-N line.

As shown in FIG. 28 and FIG. 29, the display module 100 includes a display 10, a first stiffening plate 30, and a fourth stiffening plate 33.

For example, the display 10 includes a first non-bending portion 11, a first bending portion 12, a second non-bending portion 13, a second bending portion 14, and a third non-bending portion 15 that are sequentially connected. For a disposing manner and a connection manner of the first non-bending portion 11, the first bending portion 12, the second non-bending portion 13, the second bending portion 14, and the third non-bending portion 15, refer to the disposing manner and the connection manner of the first non-bending portion 11, the first bending portion 12, the second non-bending portion 13, the second bending portion 14, and the third non-bending portion 15 that are described above. Details are not described herein again.

For example, a support member 20 includes a first support portion 21, a second support portion 22, a third support portion 23, a fourth support portion 24, and a fifth support portion 25 that are sequentially connected. For a disposing manner and a connection manner of the first support portion 21, the second support portion 22, the third support portion 23, the fourth support portion 24, and the fifth support portion 25, refer to the disposing manner and the connection manner of the first support portion 21, the second support portion 22, the third support portion 23, the fourth support portion 24, and the fifth support portion 25 that are described above. Details are not described herein again.

As shown in FIG. 29, the first stiffening plate 30 is fastened to a side that is of the support member 20 and that is away from the first bending portion 12 and covers first through holes 2211 (refer to FIG. 21). When the first housing 210 (refer to FIG. 28) and the second housing 220 (refer to FIG. 28) are unfolded or folded relative to each other, both the support member 20 and the first stiffening plate 30 are bendable. For a manner of connecting the first stiffening plate 30 to the support member 20, refer to the foregoing manner of connecting the first stiffening plate 30 to the support member 20. Details are not described herein again.

In this implementation, the first stiffening plate 30 is fastened to both a first door board 3101 (refer to FIG. 19a) and a second door board 3102 (refer to FIG. 19a). For a manner of connecting the first stiffening plate 30 to the first door board 3101 (refer to FIG. 19a) and the second door board 3102 (refer to FIG. 19a), refer to the manner of connecting the first stiffening plate 30 to the first door board 3101 and the second door board 3102 in the implementation shown in FIG. 9. Details are not described herein again.

For a thickness, a hardness, and a material of the first stiffening plate 30, refer to the thickness, the hardness, and the material of the first stiffening plate 30 described above. Details are not described herein again.

As shown in FIG. 20 to FIG. 22, the fourth stiffening plate 33 is fastened to a side that is of the support member 20 and that is away from the second bending portion 14 and covers second through holes 2411 (refer to FIG. 21). When the second housing 220 (refer to FIG. 19a) and the third housing 230 (refer to FIG. 19a) are unfolded or folded relative to each other, both the support member 20 and the fourth stiffening plate 33 are bendable. For a manner of connecting the fourth stiffening plate 33 to the support member 20, refer to the foregoing manner of connecting the first stiffening plate 30 to the support member 20. Details are not described herein again.

In this implementation, the fourth stiffening plate 33 is fastened to both a third door board 3103 (refer to FIG. 19a) and a fourth door board 3104 (refer to FIG. 19a). For a manner of connecting the fourth stiffening plate 33 to the third door board 3103 (refer to FIG. 19a) and the fourth door board 3104 (refer to FIG. 19a), refer to the foregoing manner of connecting the first stiffening plate 30 to the first door board 3101 and the second door board 3102. Details are not described herein again.

For a thickness, a hardness, and a material of the fourth stiffening plate 33, refer to the thickness, the hardness, and the material of the first stiffening plate 30 described above. Details are not described herein again.

As shown in FIG. 29, the display module 100 may further include a first buffer member 40. The first buffer member 40 is fastened to a side that is of the first stiffening plate 30 and that is away from the support member 20. For a disposing manner of the first buffer member 40 and a manner of connecting the first buffer member 40 to the first stiffening plate 30, refer to the disposing manner of the first buffer member 40 described above and the manner of connecting the first buffer member 40 to the first stiffening plate 30. Details are not described herein again.

It may be understood that, in this implementation, because the first buffer member 40 is disposed at the bottom of the first stiffening plate 30, the first stiffening plate 30 may be connected to a first folding mechanism 300 (refer to FIG. 19a) by using the first buffer member 40. Details are not described herein again.

For a material of the first buffer member 40, refer to the material of the first buffer member 40 described above. Details are not described herein again.

In another implementation, the display module 100 may alternatively not include the first buffer member 40. In this case, a size of the electronic device 1000 in the thickness direction is small. This facilitates implementation of thinning of the electronic device 1000.

As shown in FIG. 29, the display module 100 may further include a second buffer member 41. The second buffer member 41 is fastened to a side that is of the fourth stiffening plate 33 and that is away from the support member 20. For a manner of connecting the second buffer member 41 to the fourth stiffening plate 33, refer to the foregoing manner of connecting the first buffer member 40 to the first stiffening plate 30. Details are not described herein again.

It may be understood that, in this implementation, because the second buffer member 41 is disposed at the bottom of the fourth stiffening plate 33, the fourth stiffening plate 33 may be connected to a second folding mechanism 310 (refer to FIG. 19a) by using the second buffer member 41. Details are not described herein again.

For a material of the second buffer member 41, refer to the material of the second buffer member 41 described above. Details are not described herein again.

In another implementation, the display module 100 may alternatively not include the second buffer member 41. In this case, a size of the electronic device 1000 in the thickness direction is small. This facilitates implementation of thinning of the electronic device 1000.

In addition, the electronic device 1000 is folded once or twice. In another implementation, the electronic device 1000 may alternatively be folded more than twice. For example, the electronic device 1000 may be folded three times, and the electronic device 1000 is folded in a "W" shape. Alternatively, the electronic device 1000 may be folded five times or seven times.

It should be noted that embodiments in this application and features in embodiments may be combined with each other when there is no conflict, and any combination of features in different embodiments also falls within the protection scope of this application. In other words, the plurality of embodiments described above may alternatively be combined based on an actual requirement.

It should be noted that all the foregoing accompanying drawings are example diagrams of this application, and do not represent actual sizes of products. In addition, a size proportional relationship between components in the accompanying drawings is not intended to limit an actual product in this application.

As shown in FIG. 20 to FIG. 22, the fifth stiffening plate 34 is located on a side that is of the support member 20 and that is away from the display 10. The fifth stiffening plate 34 may be fastened to the fifth support portion 25 of the support member 20. For a manner of connecting the fifth stiffening plate 34 to the support member 20, refer to the foregoing manner of connecting the second stiffening plate 31 to the support member 20. Details are not described herein again.

For a material, a thickness, and a hardness of the fifth stiffening plate 34, refer to the material, the thickness, and the hardness of the second stiffening plate 31 described above. Details are not described herein again.

As shown in FIG. 20 to FIG. 22, the display module 100 further includes a second buffer member 41. The second buffer member 41 is fastened to a side that is of the fourth stiffening plate 33 and that is away from the support member 20. The second buffer member 41 is further fastened to a side that is of the fifth stiffening plate 34 and that is away from the support member 20. In another implementation, the second buffer member 41 may be fastened to one or both of the fourth stiffening plate 33 and the fifth stiffening plate 34.

For a manner of connecting the second buffer member 41 to the fourth stiffening plate 33, refer to the foregoing manner of connecting the first buffer member 40 to the first stiffening plate 30. Details are not described herein again. For a manner of connecting the second buffer member 41 to the fifth stiffening plate 34, refer to the foregoing manner of connecting the first buffer member 40 to the second stiffening plate 31. Details are not described herein again.

For a material of the second buffer member 41, refer to the material of the first buffer member 40 described above. Details are not described herein again.

It may be understood that, in this implementation, because the second buffer member 41 is disposed at the bottom of the fourth stiffening plate 33 and the fifth stiffening plate 34, the fourth stiffening plate 33 and the fifth stiffening plate 34 may be connected to the second folding mechanism 310 (refer to FIG. 19a) by using the second buffer member 41. Details are not described herein again.

In another implementation, the display module 100 may alternatively not include the second buffer member 41. In this case, a size of the electronic device 1000 in the thickness direction is small. This facilitates implementation of thinning of the electronic device 1000.

FIG. 23 is a diagram of a structure of another implementation of the display module 100 shown in FIG. 20. FIG. 24 is a partial sectional view of an implementation of the display module 100 shown in FIG. 23 in the open state at a K-K line.

As shown in FIG. 23 and FIG. 24, the display module 100 includes an avoidance groove 420. An opening of the avoidance groove 420 is located on a surface of the second buffer member 41. The avoidance groove 420 runs through the fourth stiffening plate 33 and the second buffer member 41.

The electronic device 1000 includes an electronic element 421. The electronic element 421 may be fastened to the first housing 210 (refer to FIG. 16). At least a part of the electronic element 421 may be located in the avoidance groove 420. That is, the avoidance groove 420 may be used to dispose the electronic element 421. For example, the electronic element 421 may be a chip, a capacitor, a camera, a motor, a speaker, a microphone, or the like.

It may be understood that the display module 100 is provided with the avoidance groove 420, and some electronic elements 421 of the electronic device 1000 are disposed in the avoidance groove 420, so that a mounting region may be provided for these electronic elements 421. In addition, in the thickness direction of the electronic device 1000, an overlapping region exists between the electronic elements 421 and the display module 100, so that thinning of the electronic device 1000 is facilitated, and carrying experience of the user is improved.

FIG. 25 is a diagram of a structure of still another implementation of the display module 100 shown in FIG. 20.

As shown in FIG. 25, the fourth stiffening plate 33 and the fifth stiffening plate 34 may be spaced apart. In this case, a gap may exist between the fourth stiffening plate 33 and the fifth stiffening plate 34. In this way, in the process of folding and unfolding the electronic device 1000, bending stress of the display module 100 can be reduced, the anti-extrusion capability of the display 10 can be improved, and the display module 100 is not likely to be damaged due to local stress concentration. In addition, in the process of folding and unfolding the electronic device 1000, a rebound force of the display module 100 can be reduced, and opening and closing experience of the user can be improved.

The foregoing specifically describes several implementations of the tri-fold electronic device 1000 and the display module 100 with reference to related accompanying drawings. The following further specifically describes other several implementations of the tri-fold electronic device 1000 and the display module 100 with reference to related accompanying drawings.

FIG. 26 is a diagram of still another implementation of an electronic device 1000 in a closed state according to this application.

As shown in FIG. 26, the electronic device 1000 includes a first housing 210, a second housing 220, a third housing 230, and a display module 100. For a disposing manner and a connection relationship of the first housing 210, the second housing 220, and the third housing 230, refer to the disposing manner and the connection relationship of the first housing 210, the second housing 220, and the third housing 230 that are described above. For a disposing manner and a connection relationship of the display module 100, refer to the disposing manner and the connection relationship of the display module 100 described above. Specifically, technical content that is the same as the foregoing is not described herein again.

As shown in FIG. 26, when the electronic device 1000 is in the closed state, the first housing 210, the second housing 220, and the third housing 230 may be folded relative to each other. The second housing 220, the first housing 210, and the third housing 230 may be sequentially arranged and disposed in a Z-axis direction, and the first housing 210 is located between the second housing 220 and the third housing 230. The display module 100 may be in a folded state. That is, a second portion 100B and a fourth portion 100D of the display module 100 are bent. A first portion 100A, the second portion 100B, a third portion 100C, the fourth portion 100D, and a fifth portion 100E of the display module 100 are all exposed outside the housings. The display module 100 may be configured to display an image in a large area, so that user experience can be improved.

It may be understood that, when the electronic device 1000 is in the closed state, the first portion 100A, the second portion 100B, the third portion 100C, the fourth portion 100D, and the fifth portion 100E of the display module 100 are all exposed outside the housings. In this case, both the second portion 100B and the fourth portion 100D of the display module 100 are outward-bending structures.

FIG. 27 is a partial sectional view of an implementation of the display module 100 shown in FIG. 26 at an M-M line.

As shown in FIG. 26 and FIG. 27, the display module 100 includes a display 10, a support member 20, a first stiffening plate 30, a second stiffening plate 31, a third stiffening plate 32, a fourth stiffening plate 33, and a fifth stiffening plate 34.

For example, the display 10 includes a first non-bending portion 11, a first bending portion 12, a second non-bending portion 13, a second bending portion 14, and a third non-bending portion 15 that are sequentially connected. For a disposing manner and a connection manner of the first non-bending portion 11, the first bending portion 12, the second non-bending portion 13, the second bending portion 14, and the third non-bending portion 15, refer to the disposing manner and the connection manner of the first non-bending portion 11, the first bending portion 12, the second non-bending portion 13, the second bending portion 14, and the third non-bending portion 15 that are described above. Details are not described herein again.

For example, the support member 20 includes a first support portion 21, a second support portion 22, a third support portion 23, a fourth support portion 24, and a fifth support portion 25 that are sequentially connected. For a disposing manner and a connection manner of the first support portion 21, the second support portion 22, the third support portion 23, the fourth support portion 24, and the fifth support portion 25, refer to the disposing manner and the connection manner of the first support portion 21, the second support portion 22, the third support portion 23, the fourth support portion 24, and the fifth support portion 25 that are described above. Details are not described herein again.

As shown in FIG. 27, the first stiffening plate 30, the second stiffening plate 31, the third stiffening plate 32, the fourth stiffening plate 33, and the fifth stiffening plate 34 are all located on a side that is of the support member 20 and that is away from the display 10. For a disposing manner of the first stiffening plate 30, the second stiffening plate 31, the third stiffening plate 32, the fourth stiffening plate 33, and the fifth stiffening plate 34, and a manner of connecting the first stiffening plate 30, the second stiffening plate 31, the third stiffening plate 32, the fourth stiffening plate 33, and the fifth stiffening plate 34 to the support member 20, refer to the manner of disposing the first stiffening plate 30, the second stiffening plate 31, the third stiffening plate 32, the fourth stiffening plate 33, and the fifth stiffening plate 34 that are described above and the manner of connecting the first stiffening plate 30, the second stiffening plate 31, the third stiffening plate 32, the fourth stiffening plate 33, and the fifth stiffening plate 34 to the support member 20. Details are not described herein again.

As shown in FIG. 27, the display module 100 further includes a first buffer member 40. For a disposing manner of the first buffer member 40 and a manner of connecting the first buffer member 40 to the first stiffening plate 30, the second stiffening plate 31, and the third stiffening plate 32, refer to the disposing manner of the first buffer member 40 described above and the manner of connecting the first buffer member 40 to the first stiffening plate 30, the second stiffening plate 31, and the third stiffening plate 32. Details are not described herein again.

It may be understood that, in this implementation, because the first buffer member 40 is disposed at the bottom of the first stiffening plate 30, the second stiffening plate 31, and the third stiffening plate 32, the first stiffening plate 30, the second stiffening plate 31, and the third stiffening plate 32 may be connected to the first folding mechanism 300 (refer to FIG. 19a) by using the first buffer member 40. Details are not described herein again.

As shown in FIG. 27, the display module 100 may further include a second buffer member 41. For a disposing manner of the second buffer member 41 and a manner of connecting the second buffer member 41 to the fourth stiffening plate 33 and the fifth stiffening plate 34, refer to the disposing manner of the second buffer member 41 described above and the manner of connecting the second buffer member 41 to the fourth stiffening plate 33 and the fifth stiffening plate 34. Details are not described herein again.

It may be understood that, in this implementation, because the second buffer member 41 is disposed at the bottom of the fourth stiffening plate 33 and the fifth stiffening plate 34, the fourth stiffening plate 33 and the fifth stiffening plate 34 may be connected to the second folding mechanism 310 (refer to FIG. 19a) by using the second buffer member 41. Details are not described herein again.

In an implementation, the display module 100 includes an avoidance groove (not shown in the figure). For a disposing manner of the avoidance groove, refer to the disposing manner of the avoidance groove 410 and/or the avoidance groove 420 described above. Details are not described herein again.

In this implementation, the electronic device 1000 includes an electronic element (not shown in the figure). The electronic element may be a chip, a capacitor, a camera, a motor, a speaker, a microphone, or the like. For a disposing manner of the electronic element, refer to the disposing manner of the electronic element 411 and/or the electronic element 421 described above. Details are not described herein again.

FIG. 28 is a diagram of yet another implementation of an electronic device 1000 in a closed state according to an embodiment of this application.

As shown in FIG. 28, the electronic device 1000 includes a first housing 210, a second housing 220, a third housing 230, and a display module 100. For a disposing manner and a connection relationship of the first housing 210, the second housing 220, and the third housing 230, refer to the disposing manner and the connection relationship of the first housing 210, the second housing 220, and the third housing 230 that are described above. For a disposing manner and a connection relationship of the display module 100, refer to the disposing manner and the connection relationship of the display module 100 described above. Specifically, technical content that is the same as the foregoing is not described herein again.

As shown in FIG. 28, when the electronic device 1000 is in the closed state, the first housing 210, the second housing 220, and the third housing 230 may be folded relative to each other. The second housing 220, the third housing 230, and the first housing 210 may be sequentially arranged and disposed in a Z-axis direction, and the third housing 230 is located between the first housing 210 and the second housing 220. The display module 100 may be in a folded state. That is, a second portion 100B and a fourth portion 100D of the display module 100 are bent. A first portion 100A of the display module 100 is located between the first housing 210 and the third housing 230. A third portion 100C and a fifth portion 100E of the display module 100 are located between the second housing 220 and the third housing 230. In this case, the first portion 100A, the second portion 100B, the third portion 100C, the fourth portion 100D, and the fifth portion 100E of the display module 100 are all protected by the housings. This helps reduce a probability that the display module 100 is damaged.

It may be understood that, when the electronic device 1000 is in the closed state, the first portion 100A, the second portion 100B, the third portion 100C, the fourth portion 100D, and the fifth portion 100E of the display module 100 are all accommodated among the first housing 210, the second housing 220, and the third housing 230. In this case, both the second portion 100B and the fourth portion 100D of the display module 100 are inward-bending structures.

FIG. 29 is a partial sectional view of an implementation of the display module 100 shown in FIG. 28 at an N-N line.

As shown in FIG. 28 and FIG. 29, the display module 100 includes a display 10, a first stiffening plate 30, and a fourth stiffening plate 33.

For example, the display 10 includes a first non-bending portion 11, a first bending portion 12, a second non-bending portion 13, a second bending portion 14, and a third non-bending portion 15 that are sequentially connected. For a disposing manner and a connection manner of the first non-bending portion 11, the first bending portion 12, the second non-bending portion 13, the second bending portion 14, and the third non-bending portion 15, refer to the disposing manner and the connection manner of the first non-bending portion 11, the first bending portion 12, the second non-bending portion 13, the second bending portion 14, and the third non-bending portion 15 that are described above. Details are not described herein again.

For example, a support member 20 includes a first support portion 21, a second support portion 22, a third support portion 23, a fourth support portion 24, and a fifth support portion 25 that are sequentially connected. For a disposing manner and a connection manner of the first support portion 21, the second support portion 22, the third support portion 23, the fourth support portion 24, and the fifth support portion 25, refer to the disposing manner and the connection manner of the first support portion 21, the second support portion 22, the third support portion 23, the fourth support portion 24, and the fifth support portion 25 that are described above. Details are not described herein again.

As shown in FIG. 29, the first stiffening plate 30 is fastened to a side that is of the support member 20 and that is away from the first bending portion 12 and covers first through holes 2211 (refer to FIG. 21). When the first housing 210 (refer to FIG. 28) and the second housing 220 (refer to FIG. 28) are unfolded or folded relative to each other, both the support member 20 and the first stiffening plate 30 are bendable. For a manner of connecting the first stiffening plate 30 to the support member 20, refer to the foregoing manner of connecting the first stiffening plate 30 to the support member 20. Details are not described herein again.

In this implementation, the first stiffening plate 30 is fastened to both a first door board 3101 (refer to FIG. 19a) and a second door board 3102 (refer to FIG. 19a). For a manner of connecting the first stiffening plate 30 to the first door board 3101 (refer to FIG. 19a) and the second door board 3102 (refer to FIG. 19a), refer to the manner of connecting the first stiffening plate 30 to the first door board 3101 and the second door board 3102 in the implementation shown in FIG. 9. Details are not described herein again.

For a thickness, a hardness, and a material of the first stiffening plate 30, refer to the thickness, the hardness, and the material of the first stiffening plate 30 described above. Details are not described herein again.

As shown in FIG. 20 to FIG. 22, the fourth stiffening plate 33 is fastened to a side that is of the support member 20 and that is away from the second bending portion 14 and covers second through holes 2411 (refer to FIG. 21). When the second housing 220 (refer to FIG. 19a) and the third housing 230 (refer to FIG. 19a) are unfolded or folded relative to each other, both the support member 20 and the fourth stiffening plate 33 are bendable. For a manner of connecting the fourth stiffening plate 33 to the support member 20, refer to the foregoing manner of connecting the first stiffening plate 30 to the support member 20. Details are not described herein again.

In this implementation, the fourth stiffening plate 33 is fastened to both a third door board 3103 (refer to FIG. 19a) and a fourth door board 3104 (refer to FIG. 19a). For a manner of connecting the fourth stiffening plate 33 to the third door board 3103 (refer to FIG. 19a) and the fourth door board 3104 (refer to FIG. 19a), refer to the foregoing manner of connecting the first stiffening plate 30 to the first door board 3101 and the second door board 3102. Details are not described herein again.

For a thickness, a hardness, and a material of the fourth stiffening plate 33, refer to the thickness, the hardness, and the material of the first stiffening plate 30 described above. Details are not described herein again.

As shown in FIG. 29, the display module 100 may further include a first buffer member 40. The first buffer member 40 is fastened to a side that is of the first stiffening plate 30 and that is away from the support member 20. For a disposing manner of the first buffer member 40 and a manner of connecting the first buffer member 40 to the first stiffening plate 30, refer to the disposing manner of the first buffer member 40 described above and the manner of connecting the first buffer member 40 to the first stiffening plate 30. Details are not described herein again.

It may be understood that, in this implementation, because the first buffer member 40 is disposed at the bottom of the first stiffening plate 30, the first stiffening plate 30 may be connected to a first folding mechanism 300 (refer to FIG. 19a) by using the first buffer member 40. Details are not described herein again.

For a material of the first buffer member 40, refer to the material of the first buffer member 40 described above. Details are not described herein again.

In another implementation, the display module 100 may alternatively not include the first buffer member 40. In this case, a size of the electronic device 1000 in the thickness direction is small. This facilitates implementation of thinning of the electronic device 1000.

As shown in FIG. 29, the display module 100 may further include a second buffer member 41. The second buffer member 41 is fastened to a side that is of the fourth stiffening plate 33 and that is away from the support member 20. For a manner of connecting the second buffer member 41 to the fourth stiffening plate 33, refer to the foregoing manner of connecting the first buffer member 40 to the first stiffening plate 30. Details are not described herein again.

It may be understood that, in this implementation, because the second buffer member 41 is disposed at the bottom of the fourth stiffening plate 33, the fourth stiffening plate 33 may be connected to a second folding mechanism 310 (refer to FIG. 19a) by using the second buffer member 41. Details are not described herein again.

For a material of the second buffer member 41, refer to the material of the second buffer member 41 described above. Details are not described herein again.

In another implementation, the display module 100 may alternatively not include the second buffer member 41. In this case, a size of the electronic device 1000 in the thickness direction is small. This facilitates implementation of thinning of the electronic device 1000.

In addition, the electronic device 1000 is folded once or twice. In another implementation, the electronic device 1000 may alternatively be folded more than twice. For example, the electronic device 1000 may be folded three times, and the electronic device 1000 is folded in a "W" shape. Alternatively, the electronic device 1000 may be folded five times or seven times.

It should be noted that embodiments in this application and features in embodiments may be combined with each other when there is no conflict, and any combination of features in different embodiments also falls within the protection scope of this application. In other words, the plurality of embodiments described above may alternatively be combined based on an actual requirement.

It should be noted that all the foregoing accompanying drawings are example diagrams of this application, and do not represent actual sizes of products. In addition, a size proportional relationship between components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device (1000), comprising a first housing (210), a second housing (220), a first folding mechanism (300), and a display module (100), wherein the first folding mechanism (300) is connected to the first housing (210) and the second housing (220), and the first folding mechanism (300) is configured to unfold or fold the first housing (210) and the second housing (220) relative to each other;
the display module (100) comprises a display (10), a support member (20), and a first stiffening plate (30), the display (10) comprises a first bending portion (12), a first non-bending portion (11), and a second non-bending portion (13), the first bending portion (12) is connected to the first non-bending portion (11) and the second non-bending portion (13), the first non-bending portion (11) is fastened to the first housing (210), and the second non-bending portion (13) is fastened to the second housing (220); and
the support member (20) is provided with first through holes (2211) and/or first grooves, the support member (20) is fastened to a non-display side of the display (10), the first through holes (2211) and/or the first grooves are provided opposite to the first bending portion (12), the first stiffening plate (30) is fastened to a side that is of the support member (20) and that is away from the first bending portion (12) and covers the first through holes (2211) and/or the first grooves, and when the first housing (210) and the second housing (220) are unfolded or folded relative to each other, both the support member (20) and the first stiffening plate (30) are bendable;
**characterised in that**
the first stiffening plate (30) comprises a first side portion (301), a middle portion (302), and a second side portion (303), the first side portion (301) is close to the first non-bending portion (11), and the second side portion (302) is close to the second non-bending portion (13); and
the display module (100) comprises a first adhesive (3031) and a second adhesive (3032), the first side portion (301) is fastened to a first position of the support member (20) by using the first adhesive (3031), and the second side portion (303) is fastened to a second position of the support member (20) by using the second adhesive (3032).

2. The electronic device (1000) according to claim 1, wherein the first stiffening plate (30) is made of steel, copper, aluminum, or a titanium alloy.

3. The electronic device (1000) according to claim 1 or 2, wherein a thickness of the first stiffening plate (30) ranges from 0.01 cm to 0.05 cm.

4. The electronic device (1000) according to any one of claims 1 to 3, wherein a hardness of the first stiffening plate (30) is greater than 50 Brinell hardness.

5. The electronic device (1000) according to any one of claims 1 to 4, wherein the first folding mechanism (300) further comprises a first door board (3101) and a second door board (3102), and when the electronic device (1000) is unfolded to an open state, the first door board (3101) and the second door board (3102) jointly support the display module (100); and
the electronic device (1000) further comprises a third adhesive (3033) and a fourth adhesive (3034), the first stiffening plate (30) is further fastened to the first door board (3101) by using the third adhesive (3033), and the first stiffening plate (30) is further fastened to the second door board (3102) by using the fourth adhesive (3034).

6. The electronic device (1000) according to any one of claims 1 to 5, wherein when the electronic device (1000) is in a closed state, the first bending portion (12) and the first non-bending portion (11) are exposed relative to the first housing (210) and the second housing (220), and the first housing (210) and the second housing (220) are located between the first non-bending portion (11) and the second non-bending portion (13);
the display module (100) further comprises a second stiffening plate (31), and the second stiffening plate (31) is fastened to a side that is of the support member (20) and that is away from the first non-bending portion (11); and
the second stiffening plate (31) and the first stiffening plate (30) are spaced apart, or the second stiffening plate (31) and the first stiffening plate (30) are of an integrated structure, or the second stiffening plate (31) is fastened to the first stiffening plate (30).

7. The electronic device (1000) according to claim 6, wherein the display module (100) further comprises a buffer member (40), a part of the buffer member (40) is fastened to a side that is of the first stiffening plate (30) and that is away from the support member (20), and a part of the buffer member (40) is fastened to a side that is of the second stiffening plate (31) and that is away from the support member (20).

8. The electronic device (1000) according to claim 7, wherein the display module (100) is provided with an avoidance groove (410), and an opening of the avoidance groove (410) is located on a surface that is of the buffer member (40) and that is away from the second stiffening plate (31); and
the electronic device (1000) comprises an electronic element (411), the electronic element (411) is fastened to the first housing (210), and at least a part of the electronic element (411) is located in the avoidance groove (410).

9. The electronic device (1000) according to any one of claims 1 to 8, wherein the electronic device (1000) further comprises a third housing (230) and a second folding mechanism (310), the second folding mechanism (310) is connected to the second housing (220) and the third housing (230), and the second folding mechanism (310) is configured to unfold or fold the second housing (220) and the third housing (230) relative to each other;
the display (10) further comprises a second bending portion (14) and a third non-bending portion (15) that are sequentially connected, the second bending portion (14) is connected to the second non-bending portion (13) and the third non-bending portion (15), and the third non-bending portion (15) is fastened to the third housing (230);
the support member (20) is provided with second through holes (2411) and/or second grooves, and the second through holes (2411) and/or the second grooves are provided opposite to the second bending region (14); and
the display module (100) further comprises a fourth stiffening plate (33), the fourth stiffening plate (33) is fastened to a side that is of the support member (20) and that is away from the second bending portion (14) and covers the second through holes (2411) and/or the second grooves of the support member (20), and when the second housing (220) and the third housing (230) are unfolded or folded relative to each other, both the support member (20) and the fourth stiffening plate (33) are bendable.

10. The electronic device (1000) according to claim 9, wherein when the electronic device (1000) is in the closed state, the display module (100) is in an S shape or a G shape.

## Patentansprüche

1. Elektronische Vorrichtung (1000), umfassend ein erstes Gehäuse (210), ein zweites Gehäuse (220), einen ersten Faltmechanismus (300) und ein Anzeigemodul (100), wobei der erste Faltmechanismus (300) mit dem ersten Gehäuse (210) und dem zweiten Gehäuse (220) verbunden ist und der erste Faltmechanismus (300) konfiguriert ist, um das erste Gehäuse (210) und das zweite Gehäuse (220) relativ zueinander zu entfalten oder zu falten;
das Anzeigemodul (100) eine Anzeige (10), ein Stützelement (20) und eine erste Versteifungsplatte (30) umfasst, die Anzeige (10) einen ersten Biegeabschnitt (12), einen ersten Nicht-Biegeabschnitt (11) und einen zweiten Nicht-Biegeabschnitt (13) umfasst, der erste Biegeabschnitt (12) mit dem ersten Nicht-Biegeabschnitt (11) und dem zweiten Nicht-Biegeabschnitt (13) verbunden ist, der erste Nicht-Biegeabschnitt (11) an dem ersten Gehäuse (210) befestigt ist und der zweite Nicht-Biegeabschnitt (13) an dem zweiten Gehäuse (220) befestigt ist; und
das Stützelement (20) mit ersten Durchgangslöchern (2211) und/oder ersten Nuten versehen ist, das Stützelement (20) an einer Nicht-Anzeigeseite der Anzeige (10) befestigt ist, die ersten Durchgangslöcher (2211) und/oder die ersten Nuten gegenüber dem ersten Biegeabschnitt (12) vorgesehen sind, die erste Versteifungsplatte (30) an einer Seite des Stützelements (20) befestigt ist, die von dem ersten Biegeabschnitt (12) abgewandt ist, und die ersten Durchgangslöcher (2211) und/oder die ersten Nuten abdeckt, und wenn das erste Gehäuse (210) und das zweite Gehäuse (220) relativ zueinander entfaltet oder gefaltet werden, sowohl das Stützelement (20) als auch die erste Versteifungsplatte (30) biegbar sind;
**dadurch gekennzeichnet, dass** die erste Versteifungsplatte (30) einen ersten Seitenabschnitt (301), einen Mittelabschnitt (302) und einen zweiten Seitenabschnitt (303) umfasst, der erste Seitenabschnitt (301) nahe dem ersten Nicht-Biegeabschnitt (11) ist und der zweite Seitenabschnitt (302) nahe dem zweiten Nicht-Biegeabschnitt (13) ist; und
das Anzeigemodul (100) einen ersten Klebstoff (3031) und einen zweiten Klebstoff (3032) umfasst, der erste Seitenabschnitt (301) an einer ersten Position des Stützelements (20) unter Verwendung des ersten Klebstoffs (3031) befestigt ist und der zweite Seitenabschnitt (303) an einer zweiten Position des Stützelements (20) unter Verwendung des zweiten Klebstoffs (3032) befestigt ist.

2. Elektronische Vorrichtung (1000) nach Anspruch 1, wobei die erste Versteifungsplatte (30) aus Stahl, Kupfer, Aluminium oder einer Titanlegierung hergestellt ist.

3. Elektronische Vorrichtung (1000) nach Anspruch 1 oder 2, wobei eine Dicke der ersten Versteifungsplatte (30) von 0,01 cm bis 0,05 cm reicht.

4. Elektronische Vorrichtung (1000) nach einem der Ansprüche 1 bis 3, wobei eine Härte der ersten Versteifungsplatte (30) größer als 50 Brinell-Härte ist.

5. Elektronische Vorrichtung (1000) nach einem der Ansprüche 1 bis 4, wobei der erste Faltmechanismus (300) ferner ein erstes Türbrett (3101) und ein zweites Türbrett (3102) umfasst, und wenn die elektronische Vorrichtung (1000) in einen offenen Zustand entfaltet ist, das erste Türbrett (3101) und das zweite Türbrett (3102) das Anzeigemodul (100) gemeinsam stützen; und
die elektronische Vorrichtung (1000) ferner einen dritten Klebstoff (3033) und einen vierten Klebstoff (3034) umfasst, die erste Versteifungsplatte (30) ferner an dem ersten Türbrett (3101) unter Verwendung des dritten Klebstoffs (3033) befestigt ist und die erste Versteifungsplatte (30) ferner an dem zweiten Türbrett (3102) unter Verwendung des vierten Klebstoffs (3034) befestigt ist.

6. Elektronische Vorrichtung (1000) nach einem der Ansprüche 1 bis 5, wobei, wenn sich die elektronische Vorrichtung (1000) in einem geschlossenen Zustand befindet, der erste Biegeabschnitt (12) und der erste Nicht-Biegeabschnitt (11) relativ zu dem ersten Gehäuse (210) und dem zweiten Gehäuse (220) freiliegen und sich das erste Gehäuse (210) und das zweite Gehäuse (220) zwischen dem ersten Nicht-Biegeabschnitt (11) und dem zweiten Nicht-Biegeabschnitt (13) befinden;
das Anzeigemodul (100) ferner eine zweite Versteifungsplatte (31) umfasst und die zweite Versteifungsplatte (31) an einer Seite des Stützelements (20) befestigt ist, die von dem ersten Nicht-Biegeabschnitt (11) abgewandt ist; und
die zweite Versteifungsplatte (31) und die erste Versteifungsplatte (30) voneinander beabstandet sind oder die zweite Versteifungsplatte (31) und die erste Versteifungsplatte (30) eine integrierte Struktur aufweisen oder die zweite Versteifungsplatte (31) an der ersten Versteifungsplatte (30) befestigt ist.

7. Elektronische Vorrichtung (1000) nach Anspruch 6, wobei das Anzeigemodul (100) ferner ein Pufferelement (40) umfasst, ein Teil des Pufferelements (40) an einer Seite der ersten Versteifungsplatte (30) befestigt ist, die von dem Stützelement (20) abgewandt ist, und ein Teil des Pufferelements (40) an einer Seite der zweiten Versteifungsplatte (31) befestigt ist, die von dem Stützelement (20) abgewandt ist.

8. Elektronische Vorrichtung (1000) nach Anspruch 7, wobei das Anzeigemodul (100) mit einer Ausweichnut (410) versehen ist und sich eine Öffnung der Ausweichnut (410) auf einer Oberfläche des Pufferelements (40) befindet, die von der zweiten Versteifungsplatte (31) abgewandt ist; und
die elektronische Vorrichtung (1000) ein elektronisches Element (411) umfasst, das elektronische Element (411) an dem ersten Gehäuse (210) befestigt ist und sich mindestens ein Teil des elektronischen Elements (411) in der Ausweichnut (410) befindet.

9. Elektronische Vorrichtung (1000) nach einem der Ansprüche 1 bis 8, wobei die elektronische Vorrichtung (1000) ferner ein drittes Gehäuse (230) und einen zweiten Faltmechanismus (310) umfasst, der zweite Faltmechanismus (310) mit dem zweiten Gehäuse (220) und dem dritten Gehäuse (230) verbunden ist und der zweite Faltmechanismus (310) konfiguriert ist, um das zweite Gehäuse (220) und das dritte Gehäuse (230) relativ zueinander zu entfalten oder zu falten;
die Anzeige (10) ferner einen zweiten Biegeabschnitt (14) und einen dritten Nicht-Biegeabschnitt (15) umfasst, die aufeinanderfolgend verbunden sind, der zweite Biegeabschnitt (14) mit dem zweiten Nicht-Biegeabschnitt (13) und dem dritten Nicht-Biegeabschnitt (15) verbunden ist und der dritte Nicht-Biegeabschnitt (15) an dem dritten Gehäuse (230) befestigt ist; das Stützelement (20) mit zweiten Durchgangslöchern (2411) und/oder zweiten Nuten versehen ist und die zweiten Durchgangslöcher (2411) und/oder die zweiten Nuten gegenüber dem zweiten Biegebereich (14) vorgesehen sind; und
das Anzeigemodul (100) ferner eine vierte Versteifungsplatte (33) umfasst, die vierte Versteifungsplatte (33) an einer Seite des Stützelements (20) befestigt ist, die von dem zweiten Biegeabschnitt (14) abgewandt ist, und die zweiten Durchgangslöcher (2411) und/oder die zweiten Nuten des Stützelements (20) abdeckt, und wenn das zweite Gehäuse (220) und das dritte Gehäuse (230) relativ zueinander entfaltet oder gefaltet werden, sowohl das Stützelement (20) als auch die vierte Versteifungsplatte (33) biegbar sind.

10. Elektronische Vorrichtung (1000) nach Anspruch 9, wobei, wenn sich die elektronische Vorrichtung (1000) in dem geschlossenen Zustand befindet, das Anzeigemodul (100) in einer S-Form oder einer G-Form ist.

## Revendications

1. Dispositif électronique (1000), comprenant un premier boîtier (210), un deuxième boîtier (220), un premier mécanisme de pliage (300) et un module d'affichage (100), dans lequel le premier mécanisme de pliage (300) est connecté au premier boîtier (210) et au deuxième boîtier (220), et le premier mécanisme de pliage (300) est configuré pour déplier ou plier le premier boîtier (210) et le deuxième boîtier (220) l'un par rapport à l'autre ;
le module d'affichage (100) comprend un affichage (10), un élément de support (20) et une première plaque de renfort (30), l'affichage (10) comprend une première partie pliable (12), une première partie non pliable (11) et une deuxième partie non pliable (13), la première partie pliable (12) est connectée à la première partie non pliable (11) et à la deuxième partie non pliable (13), la première partie non pliable (11) est fixée au premier boîtier (210) et la deuxième partie non pliable (13) est fixée au deuxième boîtier (220) ; et
l'élément de support (20) est doté de premiers trous traversants (2211) et/ou de premières rainures, l'élément de support (20) est fixé à un côté de non-affichage de l'affichage (10), les premiers trous traversants (2211) et/ou les premières rainures sont disposés à l'opposé de la première partie pliable (12), la première plaque de renfort (30) est fixée à un côté qui est de l'élément de support (20) et qui est éloigné de la première partie pliable (12) et recouvre les premiers trous traversants (2211) et/ou les premières rainures, et lorsque le premier boîtier (210) et le deuxième boîtier (220) sont dépliés ou pliés l'un par rapport à l'autre, l'élément de support (20) et la première plaque de renfort (30) sont tous deux pliables ;
**caractérisé en ce que**
la première plaque de renfort (30) comprend une première partie latérale (301), une partie centrale (302) et une seconde partie latérale (303), la première partie latérale (301) est proche de la première partie non pliable (11), et la seconde partie latérale (302) est proche de la deuxième partie non pliable (13) ; et
le module d'affichage (100) comprend un premier adhésif (3031) et un deuxième adhésif (3032), la première partie latérale (301) est fixée à une première position de l'élément de support (20) à l'aide du premier adhésif (3031), et la seconde partie latérale (303) est fixée à une seconde position de l'élément de support (20) à l'aide du deuxième adhésif (3032).

2. Dispositif électronique (1000) selon la revendication 1, dans lequel la première plaque de renfort (30) est en acier, en cuivre, en aluminium ou en alliage de titane.

3. Dispositif électronique (1000) selon la revendication 1 ou 2, dans lequel une épaisseur de la première plaque de renfort (30) varie de 0,01 cm à 0,05 cm.

4. Dispositif électronique (1000) selon l'une quelconque des revendications 1 à 3, dans lequel une dureté de la première plaque de renfort (30) est supérieure à 50 HB (dureté Brinell).

5. Dispositif électronique (1000) selon l'une quelconque des revendications 1 à 4, dans lequel le premier mécanisme de pliage (300) comprend en outre un premier panneau de porte (3101) et un second panneau de porte (3102), et lorsque le dispositif électronique (1000) est déplié dans un état ouvert, le premier panneau de porte (3101) et le second panneau de porte (3102) supportent conjointement le module d'affichage (100) ; et
le dispositif électronique (1000) comprend en outre un troisième adhésif (3033) et un quatrième adhésif (3034), la première plaque de renfort (30) est en outre fixée au premier panneau de porte (3101) à l'aide du troisième adhésif (3033), et la première plaque de renfort (30) est en outre fixée au second panneau de porte (3102) à l'aide du quatrième adhésif (3034).

6. Dispositif électronique (1000) selon l'une quelconque des revendications 1 à 5, dans lequel, lorsque le dispositif électronique (1000) est dans un état fermé, la première partie pliable (12) et la première partie non pliable (11) sont exposées par rapport au premier boîtier (210) et au deuxième boîtier (220), et le premier boîtier (210) et le deuxième boîtier (220) sont situés entre la première partie non pliable (11) et la deuxième partie non pliable (13) ;
le module d'affichage (100) comprend en outre une deuxième plaque de renfort (31), et la deuxième plaque de renfort (31) est fixée à un côté qui est de l'élément de support (20) et qui est éloigné de la première partie non pliable (11) ; et
la deuxième plaque de renfort (31) et la première plaque de renfort (30) sont espacées, ou la deuxième plaque de renfort (31) et la première plaque de renfort (30) sont d'une structure intégrée, ou la deuxième plaque de renfort (31) est fixée à la première plaque de renfort (30).

7. Dispositif électronique (1000) selon la revendication 6, dans lequel le module d'affichage (100) comprend en outre un élément tampon (40), une partie de l'élément tampon (40) est fixée à un côté qui est de la première plaque de renfort (30) et qui est éloigné de l'élément de support (20), et une partie de l'élément tampon (40) est fixée à un côté qui est de la deuxième plaque de renfort (31) et qui est éloigné de l'élément de support (20).

8. Dispositif électronique (1000) selon la revendication 7, dans lequel le module d'affichage (100) est doté d'une rainure d'évitement (410), et une ouverture de la rainure d'évitement (410) est située sur une surface qui est de l'élément tampon (40) et qui est éloignée de la deuxième plaque de renfort (31) ; et
le dispositif électronique (1000) comprend un élément électronique (411), l'élément électronique (411) est fixé au premier boîtier (210), et au moins une partie de l'élément électronique (411) est située dans la rainure d'évitement (410).

9. Dispositif électronique (1000) selon l'une quelconque des revendications 1 à 8, dans lequel le dispositif électronique (1000) comprend en outre un troisième boîtier (230) et un second mécanisme de pliage (310), le second mécanisme de pliage (310) est connecté au deuxième boîtier (220) et au troisième boîtier (230), et le second mécanisme de pliage (310) est configuré pour déplier ou plier le deuxième boîtier (220) et le troisième boîtier (230) l'un par rapport à l'autre ;
l'affichage (10) comprend en outre une seconde partie pliable (14) et une troisième partie non pliable (15) qui sont connectées séquentiellement, la seconde partie pliable (14) est connectée à la deuxième partie non pliable (13) et à la troisième partie non pliable (15), et la troisième partie non pliable (15) est fixée au troisième boîtier (230) ;
l'élément de support (20) est doté de seconds trous traversants (2411) et/ou de secondes rainures, et les seconds trous traversants (2411) et/ou les secondes rainures sont disposés à l'opposé de la seconde région de pliage (14) ; et
le module d'affichage (100) comprend en outre une quatrième plaque de renfort (33), la quatrième plaque de renfort (33) est fixée à un côté qui est de l'élément de support (20) et qui est éloigné de la seconde partie pliable (14) et recouvre les seconds trous traversants (2411) et/ou les secondes rainures de l'élément de support (20), et lorsque le deuxième boîtier (220) et le troisième boîtier (230) sont dépliés ou pliés l'un par rapport à l'autre, l'élément de support (20) et la quatrième plaque de renfort (33) sont tous deux pliables.

10. Dispositif électronique (1000) selon la revendication 9, dans lequel, lorsque le dispositif électronique (1000) est dans l'état fermé, le module d'affichage (100) est en forme de S ou en forme de G.
